# EUROPEAN PATENT SPECIFICATION

(11) **EP 4 538 773 B1**
(45) Date of publication and mention of the grant of the patent: **30.09.2026**
(21) Application number: 23850286.8
(22) Date of filing: 14.07.2023
(51) Int. Cl.: G02B 27/01, G06F 1/16, G06F 1/20, G02C 5/14, G02C 5/18, G02C 11/00

(54) **WEARABLE ELECTRONIC DEVICE COMPRISING HEAT TRANSFER MEMBER**
TRAGBARE ELEKTRONISCHE VORRICHTUNG MIT WÄRMEÜBERTRAGUNGSELEMENT
DISPOSITIF ÉLECTRONIQUE HABITRONIQUE COMPRENANT UN ÉLÉMENT DE TRANSFERT DE CHALEUR

(30) Priority: 02.08.2022 KR 20220095937; 31.08.2022 KR 20220109943
(43) Date of publication of application: 16.04.2025
(73) Proprietor: Samsung Electronics Co., Ltd., Suwon-si, Gyeonggi-do 16677 (KR)
(72) Inventor: IM, Jongkyun, Suwon-si, Gyeonggi-do 16677 (KR); LEE, Seunghoon, Suwon-si, Gyeonggi-do 16677 (KR); YANG, Soonwoong, Suwon-si, Gyeonggi-do 16677 (KR); JUNG, Sangchul, Suwon-si, Gyeonggi-do 16677 (KR)
(74) Representative: HGF
(86) International application number: PCT/KR2023/010094
(87) International publication number: WO 2024/029779

(56) References cited:
- CN-A- 110 703 907
- CN-A- 111 726 972
- CN-A- 112 099 237
- CN-A- 114 624 890
- CN-B- 107 209 387
- CN-U- 215 986 759
- KR-A- 20220 096 144
- US-A1- 2018 376 626

## Description

### [Technical Field]

The disclosure relates to a wearable electronic device including a heat transfer member.

### [Background Art]

A wearable electronic device in the form of glasses (e.g., AR glasses) may include a rim on which a display is disposed, and a temple which can be worn on the body of a user. The temple may be connected to the rim through a hinge, and can be opened or closed using the hinge. The temple may include a bendable area and thus be bent to be fitted to the body of a user wearing the wearable electronic device.

The temple of a wearable electronic device in the form of glasses may include a housing. A hardware component may be disposed in the housing of the temple. For example, a printed circuit board and a battery may be arranged inside the housing. An application processor (AP) may be disposed on one surface of the printed circuit board disposed inside the housing of the temple.

CN 111 726 972 A describes smart glasses comprising a thermal management structure.

### [Disclosure of Invention]

### [Technical Problem]

In case that a wearable electronic device (e.g., AR glasses) operates, an application processor disposed on a printed circuit board may generate heat. In order to prevent a malfunction of the wearable electronic device due to heat generated in the application processor, the wearable electronic device may be required to have a structure in which heat is transferred to the entire area of a temple and thus cooled.

Since the amount of heat generated in a battery of the wearable electronic device is relatively small compared to the amount of heat generated in a printed circuit board, it is necessary to transfer the heat generated in the printed circuit board toward the side in which the battery is positioned. However, due to a bendable area included in a temple, it may be limited that the heat generated in the printed circuit board is transferred in the side in which the battery is positioned. For example, even though a heat dissipating member for heat transfer is disposed in the bendable area, the heat dissipating member may be damaged by the stress generated during the bending operation of the temple.

### [Solution to Problem]

The invention as defined in claim 1.

### [Advantageous Effects of Invention]

An electronic device according to an embodiment of the disclosure may include a first heat transfer member formed to extend along the direction in which a temple extends, so as to easily diffuse heat of a temple to another area positioned relatively far away from a heat generating source.

An electronic device according to an embodiment of the disclosure may include a second heat transfer member which is positioned in a bendable area of a temple and includes a slit, so as to improve heat transfer efficiency inside a temple without interfering with bending operation of the temple.

### [Brief Description of Drawings]

FIG. 1 is a block diagram of an electronic device in a network environment according to an embodiment.
FIG. 2 is a view showing an overall configuration of an electronic device including multiple cameras according to an embodiment of the disclosure.
FIGS. 3A and 3B are views showing an electronic device according to an embodiment of the disclosure.
FIG. 4 is an exploded perspective view of a temple according to an embodiment of the disclosure.
FIG. 5A, FIG. 5B, and FIG. 5C are views showing a first housing according to an embodiment of the disclosure.
FIG. 6A, FIG. 6B, FIG. 6C, and FIG. 6D are views showing a second housing according to an embodiment of the disclosure.
FIG. 7A and FIG. 7B are views showing a temple and a cross section of the temple according to an embodiment of the disclosure.
FIG. 8A, FIG. 8B, FIG. 8C, FIG. 8D, and FIG. 8E are views showing a second heat transfer member according to an embodiment of the disclosure.
FIG. 9A and FIG. 9B are views showing a second heat transfer member according to an embodiment of the disclosure.
FIG. 10A and FIG. 10B are views showing a first heat transfer member and a second heat transfer member which are integrally manufactured and formed according to an embodiment of the disclosure.
FIG. 11A, FIG. 11B, FIG. 11C, and FIG. 11D are views showing a first housing and a third heat transfer member according to an embodiment of the disclosure.
FIG. 12 is a view showing a heat flow generated during operation of an electronic device according to an embodiment of the disclosure.

### [Mode for the Invention]

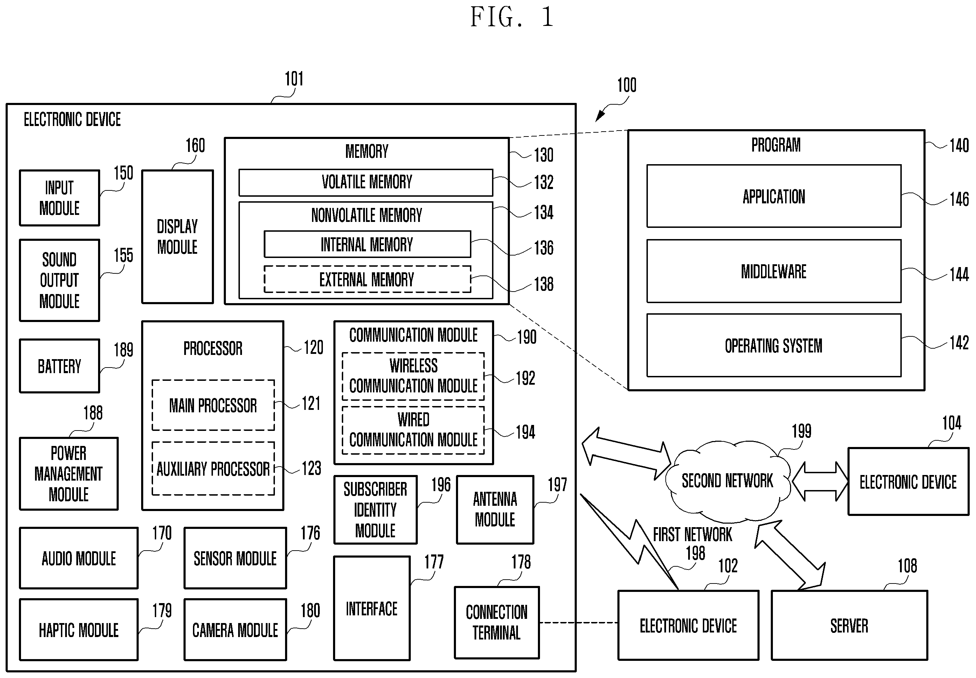

Fig. 1 is a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

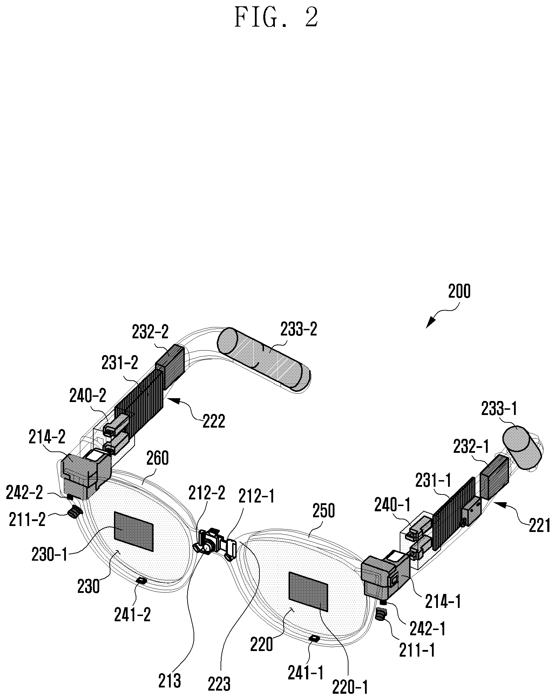

FIG. 2 is a view showing an overall configuration of an electronic device (e.g., the electronic device 101 in FIG. 1) including multiple cameras according to an embodiment of the disclosure.

In an embodiment, the electronic device 200 may be an electronic device 200 manufactured in a type which is worn on the head portion of a user. For example, the electronic device 200 may be configured in the form of at least one of glasses, goggles, a helmet, or a hat, but is not limited thereto. According to an embodiment, the electronic device 200 may include multiple glass members (e.g., the first glass member 220 and/or the second glass member 230) corresponding to both eyes (e.g., the left eye and/or the right eye) of a user, respectively.

The electronic device 200 may provide an image related to an augmented reality (AR) service to a user. According to an embodiment, the electronic device 200 may be configured to project or display a virtual object on the first glass member 220 and/or the second glass member 230 and thus to allow at least one virtual object to be superimposed on the reality recognized by a user through the first glass member 220 and/or the second glass member 230 of the electronic device.

Referring to FIG. 2, the electronic device 200 according to an embodiment may include a body part 223, a support part (e.g., the first support part 221 and the second support part 222), and a hinge part (e.g., the first hinge part 240-1 and the second hinge part 240-2).

According to an embodiment, the body part 223 and the support part 221 or 222 may be operatively connected through the hinge part 240-1 or 240-2. The body part 223 may include a portion formed to be at least partially mounted on the nose of a user.

According to an embodiment, the support part 221 or 222 may include a support member which can be placed over the ears of a user. The support parts 221 and 222 may include a first support part 221 mounted on the left ear and/or a second support part 222 mounted on the right ear.

According to an embodiment, the first hinge part 240-1 may connect the first support part 221 and the body part 223 so that the first support part 221 is rotatable relative to the body part 223. The second hinge part 240-2 may connect the second support part 222 and the body part 223 so that the second support part 222 is rotatable relative to the body part 223. According to an embodiment, the hinge parts 240-1 and 240-2 of the electronic device 200 may be omitted. For example, the body part 223 and the support part 221 or 222 may be directly connected to each other.

According to an embodiment, the body part 223 may include at least one rim (e.g., the first rim 250 and the second rim 260), at least one glass member (e.g., the first glass member 220 and the second glass member 230), at least one display module (e.g., the first display module 214-1 and the second display module 214-2), at least one camera module (e.g., the front photographing camera module 213, an eye tracking camera module (e.g., the first eye tracking camera module 212-1 and the second eye tracking camera module 212-2)), a recognition camera module (e.g., the first recognition camera module 211-1 and the second recognition camera module 211-2), and at least one microphone (e.g., the first microphone 241-1 and the second microphone 241-2).

According to an embodiment, the rims 250 and 260 may be arranged to surround the glass members 220 and 230. For example, the first rim 250 may be disposed to surround the first glass member 220, and the second rim 260 may be disposed to surround the second glass member 230.

In case of the electronic device 200 described in FIG. 2, light generated in the display modules 214-1 and 214-2 may be projected onto the glass members 220 and 230 to display information. For example, light generated in the first display module 214-1 may be projected onto the first glass member 220, and light generated in the second display module 214-2 may be projected onto the second glass member 230. Light capable of displaying a virtual object may be projected onto the glass members 220 and 230 having at least a part formed of a transparent material, and thus a user can recognize the reality in which the virtual object is superimposed. In this case, the display module 160 described in FIG. 1 may be understood as including at least a part of the display modules 214-1 and 214-2 and the glass members 220 and 230 of the electronic device 200 illustrated in FIG. 2. However, the electronic device described in the disclosure is not limited to displaying information in the manner described above. A display module, which may be included in an electronic device, may be changed to a display module including various methods of displaying information. For example, in case that a display panel including a light emitting element made of a transparent material is embedded in the glass members 220 and 230 themselves, information may be displayed without a separate display module (e.g., the first display module 214-1 and the second display module 214-2). In this case, the display module 160 described in FIG. 1 may refer to the glass members 220 and 230 and a display panel included in the glass members.

According to an embodiment, a virtual object output through the display modules 214-1 and 214-2 may include information related to an application program executed by the electronic device 200 and/or information related to an external object positioned in a real space recognized through the glass members 220 and 230 by a user. An external object may include an object existing in real space. Hereinafter, the real space recognized through the glass members 220 and 230 by a user is referred to as a user's field of view (FoV) area. For example, the electronic device 200 may identify an external object included in at least a part of an area determined as a user's field of view (FoV) from image information related to a real space acquired through a camera module (e.g., the photographing camera module 213) of the electronic device 200. The electronic device 200 may output, through the display modules 214-1 and 214-2, a virtual object related to the identified external object.

According to an embodiment, the electronic device 200 may display a virtual object related to an augmented reality service, based on image information related to a real space acquired through the photographing camera module 213 of the electronic device 200. According to an embodiment, the electronic device 200 may display a virtual object, based on display modules (e.g., the first display module 214-1 corresponding to the left eye and/or the second display module 214-2 corresponding to the right eye) arranged to correspond to both eyes of a user. According to an embodiment, the electronic device 200 may display a virtual object, based on preset configuration information (e.g., resolution, frame rate, brightness, and/or a display area).

According to an embodiment, the glass members 220 and 230 may include a condensing lens (not shown) and/or a waveguide (e.g., the first waveguide 220-1 and/or the second waveguide 230-1). For example, the first waveguide 220-1 may be partially positioned in the first glass member 220, and the second waveguide 230-1 may be partially positioned in the second glass member 230. Light emitted from the display module 214-1 or 214-2 may be incident on one surface of the glass member 220 or 230. Light incident on one surface of the glass member 220 or 230 may be transmitted to a user through the waveguide 220-1 or 230-1 positioned in the glass member 220 or 230. The waveguide 220-1 or 230-1 may be made of glass, plastic, or polymer, and may include a nano-pattern formed on an inner surface or an outer surface thereof. For example, the nano-pattern may include a grating structure having a polygonal or curved shape. According to an embodiment, light having been incident on one surface of the glass member 220 or 230 may be propagated or reflected inside the waveguide 220-1 or 230-1 by the nano-pattern and then be transmitted to a user. According to an embodiment, the waveguides 220 and 230 may include at least one diffractive element (e.g., a diffractive optical element (DOE) or a holographic optical element (HOE)) or at least one reflective element (e.g., a reflective mirror). According to an embodiment, the waveguides 220 and 230 may guide light emitted from the display modules 214-1 and 214-2 to the eyes of a user by using at least one diffractive element or reflective element.

According to an embodiment, the electronic device 200 may include a photographing camera module 213 (e.g., an RGB camera module) for photographing an image corresponding to a user's field of view (FoV) and/or measuring a distance to an object, eye tracking camera modules 212-1 and 212-2 for identifying the direction of a user's gaze, and/or recognition camera modules (gesture camera modules) 211-1 and 211-2 for recognizing a predetermined space. For example, the photographing camera module 213 may photograph the direction of the front surface of the electronic device 200, and the eye tracking camera modules 212-1 and 212-2 may photograph the direction opposite to the photographing direction of the photographing camera module 213. For example, a first eye tracking camera module 212-1 may partially photograph the left eye of a user, and a second eye tracking camera module 212-2 may partially photograph the right eye of a user. According to an embodiment, the photographing camera module 213 may include a camera module having a high resolution such as a high-resolution (HR) camera module and/or a photo video (PV) camera module. According to an embodiment, the eye tracking camera modules 212-1 and 212-2 may detect the eye pupil of a user and thus track the direction of the user's gaze. The tracked gaze direction may be utilized to move the center of a virtual image including a virtual object to correspond to the gaze direction. According to an embodiment, the recognition camera modules 211-1 and 211-2 may detect a user gesture and/or a predetermined space, within a predetermined distance (e.g., a predetermined space). The recognition camera module 211-1 or 211-2 may include a camera module including a global shutter (GS). For example, the recognition camera module 211-1 or 211-2 may be a camera module including a GS capable of reducing the rolling shutter (RS) phenomenon in order to detect and track a rapid operation of hand and/or fine movements of fingers and the like.

According to an embodiment, the electronic device 200 may detect an eye corresponding to a dominant eye and/or a non-dominant eye among the left eye and/or the right eye by using at least one camera module 211-1, 211-2, 212-1, 212-2, or 213. For example, the electronic device 200 may detect an eye corresponding to a dominant eye and/or a non-dominant eye, based on the direction of a user's gaze with respect to an external object or a virtual object.

The number and the position of at least one camera module (e.g., the photographing camera module 213, the eye tracking camera modules 212-1 and 212-2, and/or the recognition camera modules 211-1 and 211-2) included in the electronic device 200 illustrated in FIG. 2 may not be limited. For example, the number and the position of at least one camera module (e.g., the photographing camera module 213, the eye tracking camera modules 212-1 and 212-2, and/or the recognition camera modules 211-1 and 211-2) may be variously changed based on the form (e.g., shape or size) of the electronic device 200.

According to an embodiment, the electronic device 200 may include at least one light emitting device (an illumination LED) (e.g., the first light emitting device 242-1 and the second light emitting device 242-2) in order to improve the accuracy of at least one camera module (e.g., the photographing camera module 213, the eye tracking camera modules 212-1 and 212-2, and/or the recognition camera modules 211-1 and 211-2). For example, the first light emitting device 242-1 may be disposed at a portion corresponding to the left eye of a user, and the second light emitting device 242-2 may be disposed at a portion corresponding to the right eye of a user. In an embodiment, the light emitting device 242-1 or 242-2 may be used as an auxiliary means for increasing the accuracy when the eye pupil of a user is photographed by the eye tracking camera module 212-1 or 212-2, and may include an IR LED for generating light of an infrared wavelength. In addition, the light emitting device 242-1 or 242-2 may be used as an auxiliary means in case that it is not easy to detect a subject to be photographed due to a dark environment or mixing and reflection of light from multiple light sources when a user's gesture is photographed by the recognition camera module 211-1 or 211-2.

According to an embodiment, the electronic device 101 may include a microphone (e.g., the first microphone 241-1 or the second microphone 241-2) for receiving a user's voice and sounds therearound. For example, the microphone 241-1 or 241-2 may be an element included in the audio module 170 in FIG. 1.

According to an embodiment, the first support part 221 and/or the second support part 222 may include a printed circuit board (PCB) (e.g., the first printed circuit board 231-1 and/or the second printed circuit board 231-2), a speaker (e.g., the first speaker 232-1 and/or the second speaker 232-2), and/or a battery (e.g., the first battery 233-1 and/or the second battery 233-2).

According to an embodiment, the speakers 232-1 and 232-2 may include a first speaker 232-1 for transmitting audio signals to the left ear of a user and a second speaker 232-2 for transmitting audio signals to the right ear of a user. The speakers 232-1 and 232-2 may be an element included in the audio module 170 in FIG. 1.

According to an embodiment, the electronic device 200 may include multiple batteries 233-1 and 233-2, and may supply power to the printed circuit boards 231-1 and 231-2 through a power management module (e.g., the power management module 188 in FIG. 1). For example, the multiple batteries 233-1 and 233-2 may be electrically connected to a power management module (e.g., the power management module 188 in FIG. 1).

In the above, the electronic device 200 has been described as a device for displaying augmented reality, but the electronic device 200 may be a device for displaying virtual reality VR. In this case, the glass members 220 and 230 may be formed of an opaque material so that a user cannot recognize a real space through the glass members 220 and 230. In addition, the glass member 230 may function as a display module 160. For example, the glass member 220 or 230 may include a display panel for displaying information.

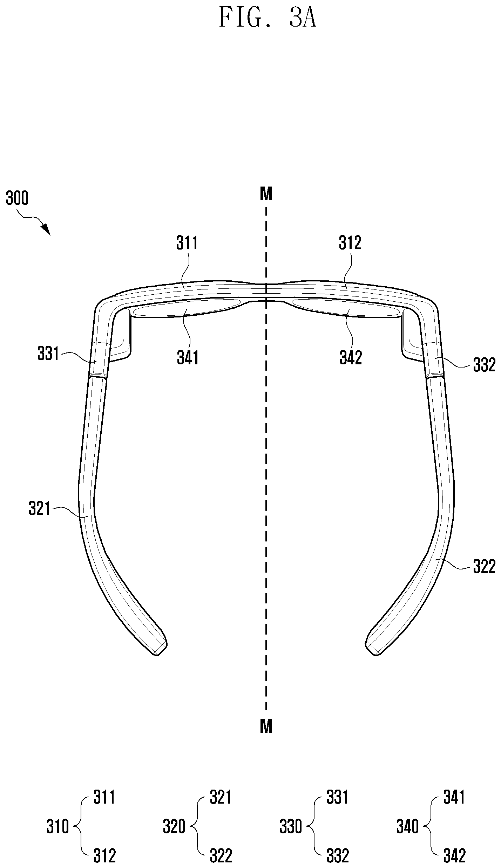

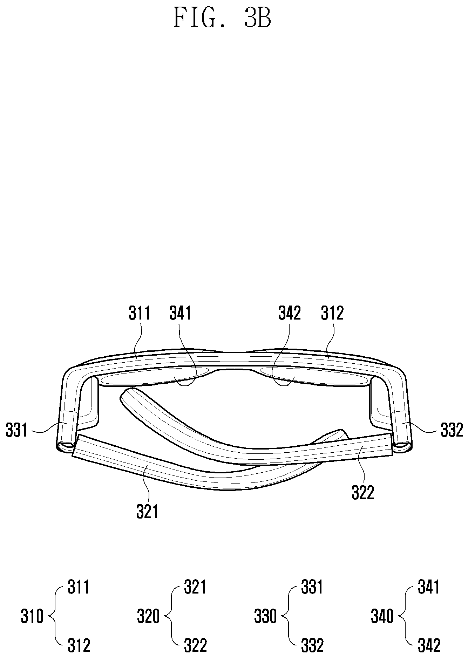

FIG. 3A and FIG. 3B are views showing an electronic device 300 according to an embodiment of the disclosure.

FIG. 3A is a view showing an electronic device 300 in an open state according to an embodiment of the disclosure.

FIG. 3B is a view showing an electronic device 300 in a closed state according to an embodiment of the disclosure.

An electronic device 300 according to an embodiment of the disclosure may include a rim 310, a temple 320, a hinge 330, and/or a glass member 340.

In an embodiment, the electronic device 300 in FIG. 3A and FIG. 3B may refer to the electronic device 200 in FIG. 2, or may be an electronic device 300 including at least a part of the electronic device 200 in FIG. 2.

The electronic device 300 according to an embodiment of the disclosure may be a wearable electronic device capable of being worn on the body of a user using the electronic device 300.

In an embodiment, an open state of the electronic device 300 may mean a state in which the temple 320 and the hinge 330 are arranged substantially in parallel to each other. A closed state of the electronic device 300 may mean a state in which the temple 320 and the hinge 330 are substantially vertically arranged or the angle formed by the temple 320 and the hinge 330 is the smallest within the rotatable range of the temple 320.

In an embodiment, the rim 310 in FIG. 3A and FIG. 3B may refer to the rim 250 or 260 in FIG. 2. The temple 320 in FIG. 3A and FIG. 3B may refer to the support part 221 or 222 in FIG. 2. The hinge 330 in FIG. 3A and FIG. 3B may refer to the hinge part 240-1 or 240-2 in FIG. 2. The glass member 340 in FIG. 3A and FIG. 3B may refer to the glass member 220 or 230 in FIG. 2.

In an embodiment, the rim 310 may include a first rim 311 and/or a second rim 312. The temple 320 may include a first temple 321 and/or a second temple 322. The hinge 330 may include a first hinge 331 and/or a second hinge 332. The glass member 340 may include a first glass member 341 and/or a second glass member 342.

In an embodiment, the electronic device 300 may be formed symmetrically with reference to a center line M-M. For example, the first rim 311 and the second rim 312, the first temple 321 and the second temple 322, the first hinge 331 and the second hinge 332, and/or the first glass member 341 and the second glass member 342 may be formed at positions symmetrical to each other with reference to the center line M-M.

In an embodiment, the first temple 321 may be connected to the first rim 311 through the first hinge 331. For example, the first temple 321 may be connected to one end of the first hinge 331, and the first rim 311 may be connected to the other end of the first hinge 331.

In an embodiment, the second temple 322 may be connected to the second rim 312 through the second hinge 332. For example, the second temple 322 may be connected to one end of the second hinge 332, and the second rim 312 may be connected to the other end of the second hinge 332.

In an embodiment, the temple 320 may include at least a part made of an elastically bendable material. The temple 320 of the electronic device 300 may be elastically bent, and thus a user of the electronic device 300 may easily wear the electronic device 300.

Referring to FIG. 3A and FIG. 3B, the temple 320 may rotate (e.g., pivot) within a predetermined range relative to the hinge 330. For example, the first temple 321 and the second temple 322 may rotate in a direction approaching the center line M-M with respect to the first hinge 331 and the second hinge 332, respectively.

In an embodiment, the temple 320 may rotate in a direction toward the center line M-M of the electronic device 300 with reference to the hinge 330 and thus be folded. For example, the hinge 330 may include a configuration capable of rotating toward the center line M-M of the electronic device 300 so that the electronic device 300 can be changed from the open state illustrated in FIG. 3A to the closed state illustrated in FIG. 3B.

In an embodiment, the temple 320 may rotate by a predetermined angle in the direction opposite to the direction toward the center line M-M of the electronic device 300 with reference to the hinge 330 and thus be folded. For example, the hinge 330 may include a configuration capable of rotating about 10 degrees around the center of the hinge 330 in the direction opposite to the direction toward the center line M-M of the electronic device 300.

In an embodiment, the glass member 340 may be disposed on the rim 310. For example, the first glass member 341 may be disposed on the first rim 311, and the second glass member 342 may be disposed on the second rim 312. The first rim 311 and the second rim 312 may be arranged to surround the peripheries of the first glass member 341 and the second glass member 342, respectively.

In an embodiment, the temple 320 may have at least a part which can be bent and extend. For example, referring to FIG. 3A, the first temple 321 and the second temple 322 may extend in one direction, and may be bent from at least a part thereof and then extend in the direction toward the center line M-M.

In an embodiment, the rim 310 and/or the glass member 340 connected to the temple 320 may include a head mount display (HMD) device. For example, the rim 310 and/or the glass member 340 may include a head mount display (HMD) device which implements virtual reality (VR), mixed reality (MR), and/or augmented reality (AR).

In an embodiment, the rim 310 and/or the glass member 340 for functioning as a head mount display (HMD) device may be connected to the temple 320 illustrated in FIG. 3A and 3B, so that the weight of the electronic device 300 can be reduced and the wearing feeling of the electronic device 300 can be improved.

In an embodiment, the rim 310 and/or the glass member 340 may be a device for implementing augmented reality (AR) and providing same to a user. For example, a user of an electronic device 300 may view an object positioned outside the electronic device through the glass member 340 in a state of wearing the electronic device 300. The glass member 340 of the electronic device 300 may display a virtual object superimposed on an image of the external object and may provide same to a user of the electronic device 300.

In an embodiment, the rim 310 and/or the glass member 340 may be a device for implementing mixed reality (MR) and providing same to a user. In case that the rim 310 and the glass member 340 are devices for implementing mixed reality, a user of the electronic device 300 may view an object positioned outside the electronic device through a camera included in the rim 310 and/or glass member 340. The electronic device 300 may provide, to a user, an image of an object existing outside the electronic device 300 and a virtual object together, through the rim 310 and/or the glass member 340, in order to be utilized together. In case that the rim 310 and/or the glass member 340 implement mixed reality (MR), a user may interact with the image provided by electronic device 300.

In an embodiment, in case that the rim 310 and/or the glass member 340 are devices for implementing mixed reality, the shape of the rim 310 and/or the glass member 340 is not limited to the shape illustrated in FIG. 3A and FIG. 3B, and may be formed in various shapes.

In an embodiment, the rim 310 and/or the glass member 340 may be a device for implementing virtual reality (VR) and providing same to a user. For example, the electronic device 300 may provide, to a user, a virtual image independent of an image of an object existing outside the electronic device, through the rim 310 and/or the glass member 340.

In an embodiment, in case that the rim 310 and/or the glass member 340 are devices for implementing virtual reality, the shape of the rim 310 and/or the glass member 340 is not limited to the shape illustrated in FIG. 3A and FIG. 3B, and may be formed in various shapes. In addition, the electronic device 300 may also further include other configurations for implementing virtual reality and providing same to a user, other configurations being provided around the rim 310 and/or the glass member 340 or inside the rim 310 and/or the glass member 340. For example, the electronic device may further include a video device (e.g., the display module 160 in FIG. 1) positioned around or inside the glass member 340 to output a virtual reality image to a user.

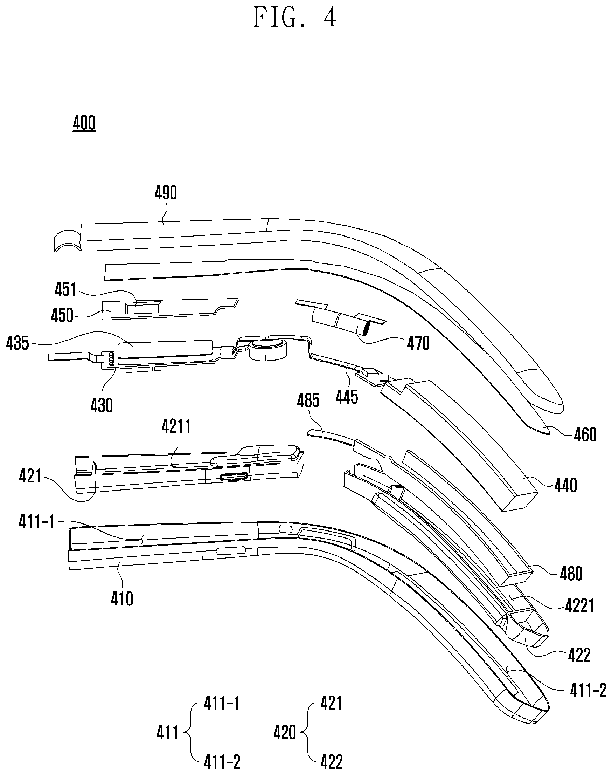

FIG. 4 is an exploded perspective view showing a temple 400 according to an embodiment of the disclosure.

In an embodiment, the temple 400 in FIG. 4 may refer to the temple 320 in FIG. 3, or may include at least a part of the temple 320 in FIG. 3. For example, the temple 400 in FIG. 4 may refer to the first temple 321 in FIG. 3 or may refer to the second temple 322 in FIG. 3.

The temple 400 according to an embodiment of the disclosure may include housings 410 and 490, a bracket 420, a printed circuit board 430, a battery 440, a heat transfer plate 450, a first heat transfer member 460, a second heat transfer member 470, and/or a third heat transfer member 480.

In an embodiment, the housings 410 and 490 may include surfaces forming the exterior of the temple 400. The housings 410 and 490 may include a first housing 410 and a second housing 490. The first housing 410 and the second housing 490 may include corresponding shapes. For example, the first housing 410 and the second housing 490 may include shapes which can be coupled to each other in at least a part thereof. At least a part of the first housing 410 may be formed in a shape which can be coupled to at least a part of the second housing 490, so that the first housing 410 and the second housing 490 can be coupled to each other.

In an embodiment, the first housing 410 may be bent and extend from at least a part thereof. For example, the first housing 410 may extend in one direction and then extend in a direction inclined by a predetermined angle from the one direction.

In an embodiment, the first housing 410 may include an accommodation space 411 in which the printed circuit board 430 and the battery 440 can be arranged.

In an embodiment, the accommodation space 411 may include a first accommodation space 411-1 and/or a second accommodation space 411-2. The first accommodation space 411-1 may mean a space formed close to one end of the first housing 410, and the second accommodation space 411-2 may mean a space formed close to the other end of the first housing 410.

In an embodiment, the printed circuit board 430 and the battery 440 may be arranged in the accommodation space 411. For example, the printed circuit board 430 may be disposed in the first accommodation space 411-1, and the battery 440 may be disposed in the second accommodation space 411-2.

In an embodiment, in case that the printed circuit board 430 and the battery 440 are arranged in the accommodation space 411, the accommodation space 411 may be formed of a material different from the material of the outer surface (e.g., the surface opposite to the accommodation space 411) of the first housing 410. For example, the material of the surface forming the accommodation space 411 may include a plastic, and the outer surface of the first housing 410 may include a deformable urethane.

In an embodiment, after the bracket 420 is disposed in the accommodation space 411 of the first housing 410, the printed circuit board 430 and the battery 440 may also be arranged in a space formed in the bracket 420. The bracket 420 may include a material (e.g., a plastic) which can protect the printed circuit board 430 and the battery 440 arranged inside the bracket from external impact.

In an embodiment, the bracket 420 may be disposed in the first housing 410. For example, a first bracket 421 may be disposed in the first accommodation space 411-1 of the first housing 410. A second bracket 422 may be disposed in the second accommodation space 411-2 of the first housing 410.

In an embodiment, the bracket 420 may include a space which is provided therein and inside which the printed circuit board 430 or the battery 440 can be arranged. For example, the printed circuit board 430 may be disposed in the first space 4211 of the first bracket 421. The battery 440 may be disposed in a second space 4221 of the second bracket 422.

In an embodiment, the first housing 410 and the bracket 420 may include different materials. For example, the first housing 410 may include a deformable urethane, and the bracket 420 may include a plastic.

In an embodiment, the printed circuit board 430 illustrated in FIG. 4 may refer to the printed circuit board 231-1 or 231-2 illustrated in FIG. 2, or may include at least a part of the printed circuit board 231-1 or 231-2 illustrated in FIG. 2.

In an embodiment, the battery 440 illustrated in FIG. 4 may refer to the battery 233-1 or 233-2 illustrated in FIG. 2, or may include at least a part of the battery 233-1 or 233-2 illustrated in FIG. 2.

In an embodiment, a heat generating component 435 may be disposed on one surface of the printed circuit board 430. For example, the heat generating component 435 may be an application processor (AP) (e.g., the processor 120 in FIG. 1) required for the operation of an electronic device 300 (see FIG. 3A), but the type thereof is not limited. For example, the heat generating component 435 may be an antenna module (e.g., the antenna module 197 in FIG. 1). For example, the heat generating component 345 may also include multiple components. In case that the electronic device 300 (see FIG. 3A) operates, the heat generating component 435 may generate heat. The heat generated in the heat generating component 435 may be transferred to at least a part of another area of the temple 400 through the heat transfer members 460, 470, and 480.

In an embodiment, the battery 440 may supply power to the printed circuit board 430. For example, a power transfer part 445 may be disposed at one end of the battery 440, and power may be supplied from the battery 440 to the printed circuit board 430 through the power transfer part 445. The power transfer part 445 may have one end electrically connected to the printed circuit board 430 and the other end electrically connected to the battery 440.

In an embodiment, the heat transfer plate 450 may be disposed on one surface of the printed circuit board 430. The heat transfer plate 450 may be formed in a plate shape having a predetermined thickness.

In an embodiment, the heat transfer plate 450 may include a contact area 451 which protrudes in a direction toward the printed circuit board 430 and comes into contact with the printed circuit board 430. The heat transfer plate 450 may be in contact with the printed circuit board 430 at the contact area 451 and may receive heat generated in the printed circuit board 430.

In an embodiment, the heat transfer plate 450 may include a metal material having high thermal conductivity. For example, the heat transfer plate 450 may include at least one of aluminum, copper, gold, silver, and/or alloys thereof.

In an embodiment, the second housing 490 may be formed in a shape corresponding to the first housing 410, and may be disposed to cover the first housing 410. For example, the perimeter of the second housing 490 and the perimeter of the first housing 410 may be in contact with each other and may extend along the same direction.

In an embodiment, the temple 400 may include the first heat transfer member 460, the second heat transfer member 470, and/or the third heat transfer member 480. The first heat transfer member 460, the second heat transfer member 470, and the third heat transfer member 480 may receive heat generated in the printed circuit board 430 or the battery 440, or may function to transfer the received heat to another area of the temple 400.

In an embodiment, the first heat transfer member 460, the second heat transfer member 470, and/or the third heat transfer member 480 may include a material allowing heat to be easily transferred. For example, the first heat transfer member 460, the second heat transfer member 470, and/or the third heat transfer member 480 may include graphite. Graphite is a material having excellent heat resistance and thermal conductivity.

In an embodiment, the first heat transfer member 460 may be disposed in the second housing 490. The first heat transfer member 460 may be formed in a plate shape extending along the direction in which the second housing 490 extends. The first heat transfer member 460 may function to transfer heat generated in the printed circuit board 430 or the battery 440 to another area inside the temple 400. For example, heat generated in the printed circuit board 430 may be transferred to the first heat transfer member 460 through the heat transfer plate 450, and the first heat transfer member 460 may transfer the received heat to the terminal end (e.g., the terminal end positioned at a side opposite to the hinge 330 (see FIG. 3A)) of the temple 400 or to the second heat transfer member 470.

In an embodiment, the second heat transfer member 470 may be disposed to be in contact with the first heat transfer member 470 in at least a part thereof. The second heat transfer member 470 may be disposed between the first bracket 421 and the second bracket 422.

In an embodiment, the third heat transfer member 480 may be disposed in the second bracket 422. For example, the third heat transfer member 480 may be formed to extend to correspond to a surface formed inside the second bracket 422.

In an embodiment, the third heat transfer member 480 may be disposed to surround at least a part of the battery 440. The third heat transfer member 480 may receive heat generated in the battery 440.

The second heat transfer member 470 according to an embodiment of the disclosure may not be in direct contact with a heat generating source (e.g., the printed circuit board 430 and the battery 440) of the temple 400. The second heat transfer member 470 may indirectly receive heat generated in the printed circuit board 430 and the battery 440 through the first heat transfer member 460 or the third heat transfer member 480.

In an embodiment, heat generated inside the temple 400 may be transferred to another area, which is positioned relatively far away from a heat generating source (e.g., the printed circuit board 430 and the battery 440), of the temple 400, through the first heat transfer member 460 or the third heat transfer member 480. In case that the first heat transfer member 460 or the third heat transfer member 480 is formed to elongate and extend, it may be easy to diffuse the heat of the temple 400 to another area which is positioned relatively far away from a heat generating source.

In an embodiment, the heat dissipating member 485 may be disposed at the terminal end of the third heat transfer member 480. For example, the heat dissipating member 485 may be disposed at the terminal end of the third heat transfer member 480, which extends in a direction toward the first bracket 421.

In an embodiment, the heat dissipating member 485 may be in contact with the second heat transfer member 470. For example, the second heat transfer member 470 may be disposed on one surface of the heat dissipating member 485 so that the heat dissipating member 485 and the second heat transfer member 470 can be in contact with each other. The heat dissipating member 485 may be in contact with the second heat transfer member 470 and thus may exchange heat with the second heat transfer member 470.

In an embodiment, the heat dissipating member 485 may include a thermal interface material (TIM). For example, the heat dissipating member 485 may be a heat interface material (TIM) including a solid material and/or a liquid material.

In an embodiment, the heat dissipating member 485 may be formed in a plate shape having a predetermined thickness. For example, referring to FIG. 4, the heat dissipating member 485 may be formed in a rectangular plate having a predetermined thickness.

In an embodiment, the shape of the heat dissipating member 485 illustrated in FIG. 4 may be an example, and the shape of the heat dissipating member 485 may not be limited thereto. For example, the heat dissipating member 485 may also be formed in a shape having another cross-section shape (e.g., circular or triangular) while having a thickness and extending, other than a rectangular cross-section.

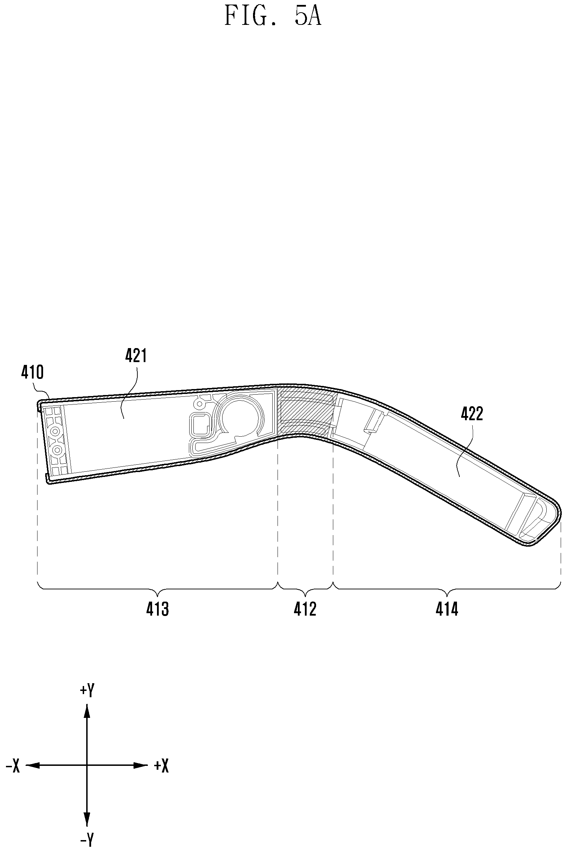

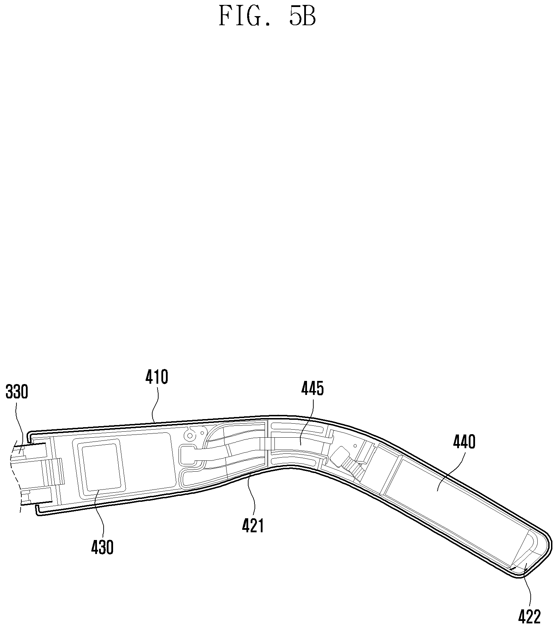

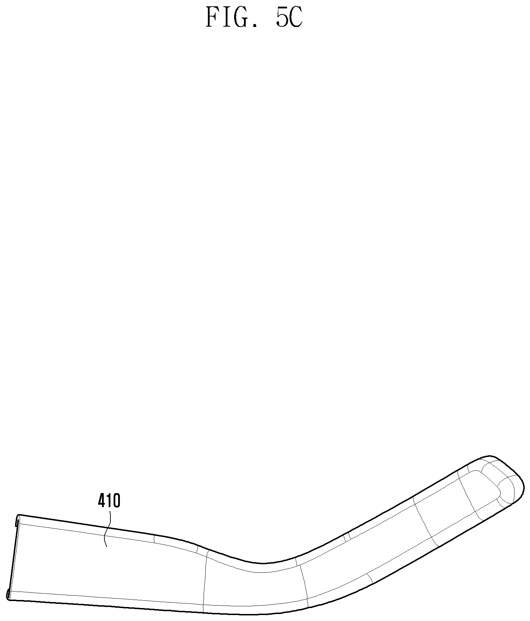

FIG. 5A, FIG. 5B, and FIG. 5C are views showing a first housing 410 according to an embodiment of the disclosure.

FIG. 5A is a view showing a first housing 410, a first bracket 421, and a second bracket 422 according to an embodiment of the disclosure.

FIG. 5B is a view showing a first housing 410, in which a printed circuit board 430 and a battery 440 are arranged, according to an embodiment of the disclosure.

FIG. 5C is a view showing the outer surface of a first housing 410 according to an embodiment of the disclosure.

The first housing 410 according to an embodiment of the disclosure may include a bendable area 412, a first area 413, and/or a second area 414.

In an embodiment, one end of the bendable area 412 may mean a terminal end positioned in the -x-axis direction with reference to the bendable area 412, and the other end of the bendable area 412 may mean a terminal end positioned in the +x-axis direction with reference to the bendable area 412.

Referring to FIG. 5A and FIG. 5B, the first area 413 may be positioned to be connected to one end of the bendable area 412. The second area 414 may be positioned to be connected to the other end of the bendable area 412.

Referring to FIG. 5A and FIG. 5B, the first area 413 of the first housing 410 may be an area which is positioned relatively close to the hinge 330 compared to other areas of the first housing 410. For example, the first area 413 may be connected to the hinge 330 at one end of the first area 413.

In an embodiment, the second area 414 of the first housing 410 may be an area which is in direct contact with the body of a user wearing the electronic device 300 (see FIG. 3A).

Referring to FIG. 5A, the first housing 410 may extend in a substantially identical direction, in the first area 413 and the bendable area 412. For example, at least a part of the first area 413 and at least a part of the bendable area 412 may extend along the x-axis direction.

Referring to FIG. 5A, the direction in which the bendable area 412 of the first housing 410 extends and the direction in which the second area 414 of the first housing 410 extends may be formed differently. For example, the bendable area 412 may extend in the x-axis direction, but the second area 414 may extend in a direction inclined by a predetermined angle from the x-axis direction toward the -y-axis direction.

In an embodiment, the first housing 410 may include an elastic material. For example, each of the bendable area 412, the first area 413, and the second area 414 may include an elastic urethane.

In an embodiment, the first area 413 and the second area 414 may have materials which are difficult to bend compared to the bendable area 412. For example, the first bracket 421 and the second bracket 422 including a plastic may be respectively arranged in the first area 413 and the second area 414, except for the bendable area 412.

In an embodiment, the bendable area 412 of the first housing 410 may not include a plastic material but only include an elastic urethane material, and thus may be relatively easily bent compared to the first area 413 and the second area 414.

Referring to FIG. 5A and FIG. 5B, the first bracket 421 and the printed circuit board 430 may be disposed in the first area 413 of the first housing 410.

Referring to FIG. 5A and FIG. 5B, the second bracket 422 and the battery 440 may be arranged in the second area 414 of the first housing 410.

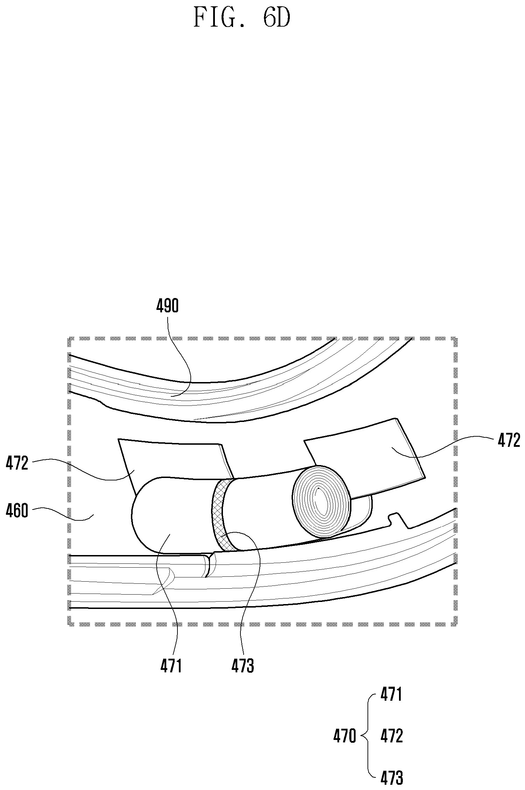

In an embodiment, the second heat transfer member 470 (see FIG. 6D) may be disposed in the bendable area 412 of the first housing 410.

Referring to FIG. 5B, the printed circuit board 430 and the battery 440 may be electrically connected to each other. For example, the printed circuit board 430 and the battery 440 may be electrically connected through the power transmission part 445.

The outer surface of the first housing 410 illustrated in FIG. 5C may include an elastic material. For example, the outer surface of the first housing 410 may be made of an elastic urethane material.

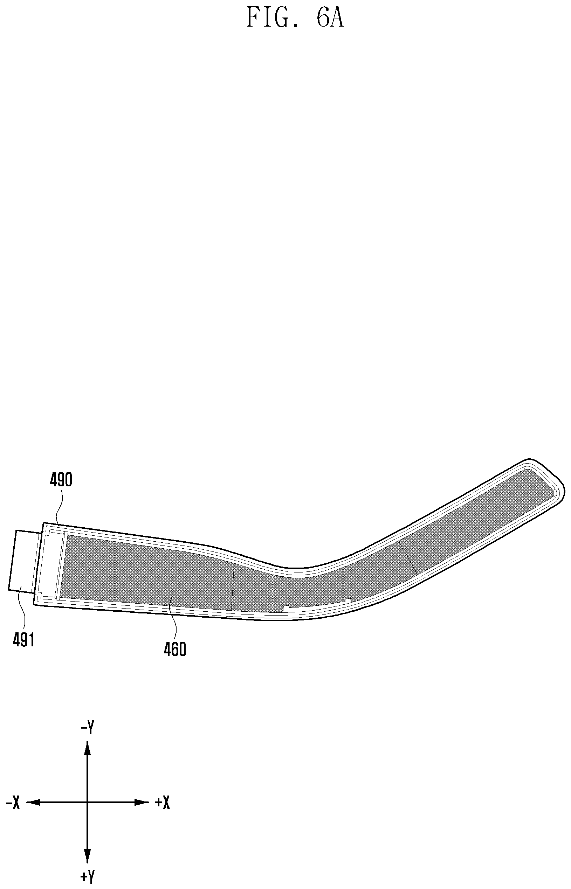

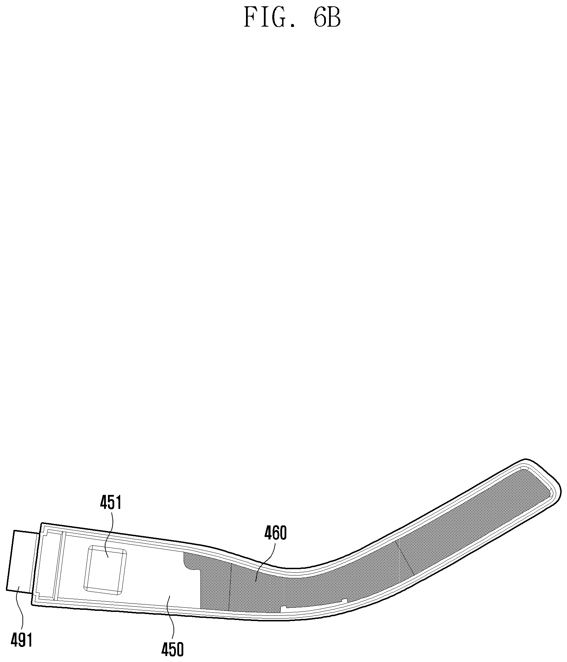

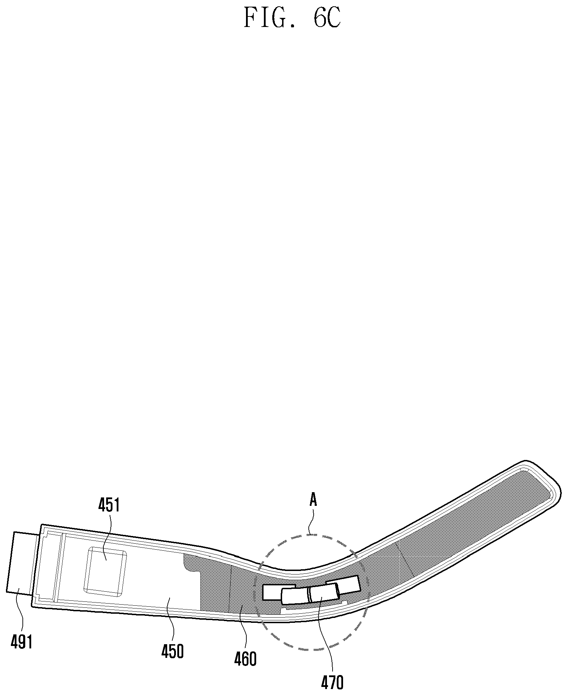

FIG. 6A, FIG. 6B, FIG. 6C, and FIG. 6D are views showing a second housing 490 according to an embodiment of the disclosure.

FIG. 6A is a view showing a second housing 490 and a first heat transfer member 460 according to an embodiment of the disclosure.

FIG. 6B is a view showing a second housing 490, a first heat transfer member 460, and a heat transfer plate 450 according to an embodiment of the disclosure.

FIG. 6C is a view showing a second housing 490, a first heat transfer member 460, a heat transfer plate 450, and a second heat transfer member 470 according to an embodiment of the disclosure.

FIG. 6D is a view showing a second heat transfer member 470 illustrated as area A in FIG. 6C.

In an embodiment, the second housing 490 may extend in one direction, and then be bent and extend from at least a part thereof. For example, referring to FIG. 6A, the second housing 490 may extend along the x-axis direction, and then be bent and extend in a direction inclined toward the -y-axis direction by a predetermined angle.

In an embodiment, a hinge coupling area 491 may be disposed at one end of the second housing 490. The hinge 330 (see FIG. 3) may be disposed in the hinge coupling area 491 of the second housing 490.

In an embodiment, the second housing 490 may include a material having a restoring force. For example, the second housing 490 may include a plastic material.

In an embodiment, the first heat transfer member 460 may be disposed in the second housing 490. The first heat transfer member 460 may have a plate shape having a predetermined thickness and may extend along the direction in which the second housing 490 extends.

Referring to FIG. 6B, the heat transfer plate 450 may be disposed in an area of the first heat transfer member 460. For example, the heat transfer plate 450 may be disposed in an area of the first heat transfer member 460, which is relatively close to the hinge coupling area 491 of the second housing 490.

In an embodiment, the heat transfer plate 450 may be formed in a plate shape having a predetermined thickness. The heat transfer plate 450 may include a metal material having high thermal conductivity. For example, the heat transfer plate 450 may include at least one of aluminum, copper, gold, silver, and/or alloys thereof.

In an embodiment, the heat transfer plate 450 may be in contact with the printed circuit board 430 (see FIG. 4). For example, the heat transfer plate 450 may be in contact with the first heat transfer member 460, on one surface thereof, and be in contact with the printed circuit board 430 (see FIG. 4), on the other surface thereof. Heat generated in the printed circuit board 430 may be transferred to the first heat transfer member 460 through the heat transfer plate 450.

In an embodiment, the heat transfer plate 450 may include a contact area 451 which is in contact with the printed circuit board 430 (see FIG. 4). The contact area 451 may be an area which protrudes in a direction toward the printed circuit board 430 (see FIG. 4), compared to other areas of the heat transfer plate 450.

Referring to FIG. 6C, a second heat transfer member 470 may be disposed on at least a part of the first heat transfer member 460. For example, the second heat transfer member 470 may be disposed in an area of one surface of the first heat transfer member 460, in which the first heat transfer member 460 is bent and extends.

In an embodiment, the second heat transfer member 470 may be disposed in an area of the second housing 490, which is positioned to correspond to the bendable area 412 (see FIG. 5A) of the first housing 410 (see FIG. 5A). For example, area A illustrated in FIG. 6C may refer to an area of the second housing 490, which is disposed at a position overlapping the bendable area 412 (see FIG. 5A) of the first housing 410 (see FIG. 5A).

In an embodiment, in case that the second housing 490 is disposed in one direction of the first housing 410 (see FIG. 5A), the second heat transfer member 470 may be disposed in the bendable area 412 (see FIG. 5A) of the first housing 410 (see FIG. 5A).

Referring to FIG. 6D, the second heat transfer member 470 may include a roll area 471, a plate area 472, and/or a slit 473.

In an embodiment, the roll area 471 may be an area in which at least a part of the second heat transfer member 470 is disposed to be wound and stacked. For example, in the roll area 471, the second heat transfer member 470 may be wound into a roll shape and may be at least partially stacked.

In FIG. 6D, although the roll area 471 is illustrated as a roll shape wound and stacked, it may be an example and the shape of the roll area 471 may not be limited thereto. For example, the roll area 471 may also have a shape in which multiple layers constituting the second heat transfer member 470 having a flat shape are stacked on each other.

In an embodiment, in case that the temple 400 has a shape in which at least a part of the second heat transfer member 470 is wound into a roll shape or multiple layers constituting the second heat transfer member 470 are arranged to be stacked on each other, the area of the second heat transfer member 470 included in the temple 400 may become relatively larger, compared to the case in which the second heat transfer member 470 is not wound and stacked or disposed as a single layer. As the area of the second heat transfer member 470 included in the temple 400 becomes relatively larger, the second heat transfer member 470 may receive more heat generated in a heat generating source (e.g., the printed circuit board 440), so that the heat transfer efficiency of the temple 400 can be improved.

In an embodiment, the plate area 472 may be an area positioned at the terminal end of the roll area 471. The terminal end of the roll area 471 may mean the terminal end of the portion positioned at the outermost of the roll area 471 wound into a roll shape. Two plate areas 472 may be arranged at the terminal end of the roll area 471.

In an embodiment, the plate area 472 of the second heat transfer member 470 may be disposed on one surface of the first heat transfer member 460. The second heat transfer member 470 may be connected to the first heat transfer member 460 through the plate area 472 so as to exchange heat.

In an embodiment, the plate area 472 may include an adhesive material and thus be directly adhered and connected to the first heat transfer member 460.

In an embodiment, a separate adhesive member (not shown) may be disposed between the plate area 472 and the first heat transfer member 460. The adhesive member (not shown) may function to connect the plate area 472 and the first heat transfer member 460. The adhesive member (not shown) may be a double-sided tape or a liquid adhesive material.

In FIG. 6D, although the shape of the plate area 472 of the second heat transfer member 470 is illustrated as a rectangular shape, it may be an example and the shape of the plate area 472 may not be limited thereto. For example, the plate area 472 may also have a circular shape or a polygonal shape other than a rectangular shape.

In FIG. 6D, although it is illustrated that the second heat transfer member 470 includes two plate areas 472, it may be an example and the number of the plate areas 472 may not be limited thereto.

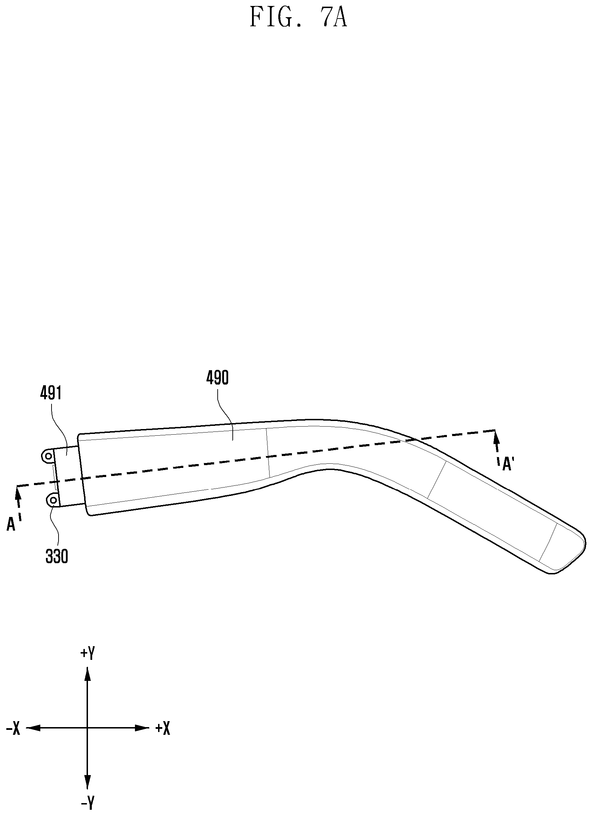

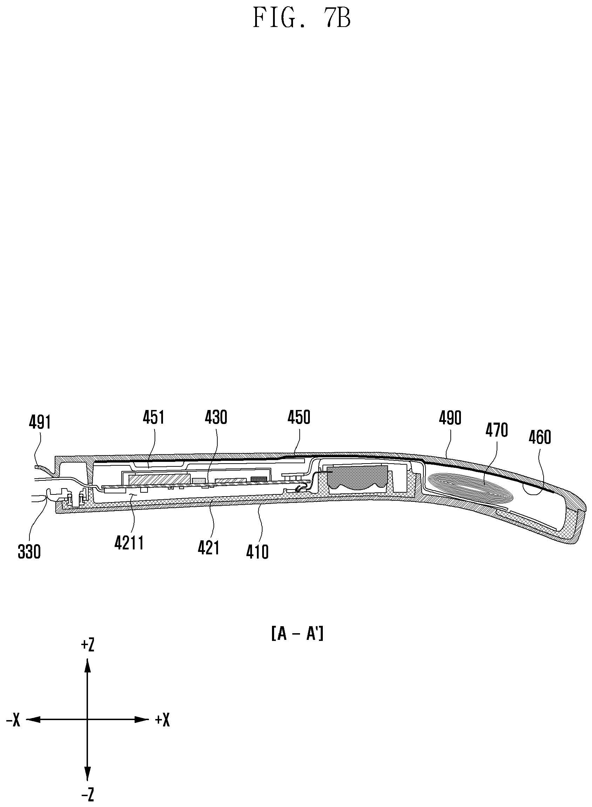

FIG. 7A and FIG. 7B are views showing a temple 400 and a cross-section of the temple 400 according to an embodiment of the disclosure.

FIG. 7A is a view showing a temple 400 according to an embodiment of the disclosure.

FIG. 7B is a cross-sectional view of a temple 400 taken along line A-A' illustrated in FIG. 7A.

In an embodiment, the lengthwise direction of the temple 400 may mean the x-axis direction, and the height direction of the temple 400 may mean the z-axis direction. The width direction of the temple 400 may mean the y-axis direction.

Referring to FIG. 7A, at least a part of the temple 400 may extend along the lengthwise direction (e.g., the x-axis direction) of the temple 400. The temple 400 may extend along the lengthwise direction (e.g., the x-axis direction) of the temple 400, and then may extend in a direction inclined by a predetermined angle toward the width direction (e.g., the -y-axis direction) of the temple 400.

Referring to FIG. 7B, the first bracket 421 may be disposed on one surface of the first housing 410. One surface of the first housing 410 may mean a surface of the first housing 410, which faces the +z-axis direction. The first bracket 421 may be disposed to be in contact with one surface of the first housing 410.

In an embodiment, the printed circuit board 430 may be disposed in the height direction (e.g., the +z-axis direction) of the temple 400 with reference to the first bracket 421. For example, the printed circuit board 430 may be disposed in the first space 4211 of the first bracket 421.

In an embodiment, the second housing 490 may be disposed at a position shifted in the height direction of the temple 400 from the first housing 410. For example, the second housing 490 may be disposed at a position shifted in the +z-axis direction with reference to the first housing 410.

In an embodiment, the printed circuit board 430 and/or the second heat transfer member 470 may be arranged between the first housing 410 and the second housing 490. For example, the first housing 410, the printed circuit board 430, and the second housing 490 may be arranged in the order thereof, with reference to the height direction (e.g., the +z-axis direction) of the temple 400. The first housing 410, the second heat transfer member 470, and the second housing 490 may be arranged in the order thereof, with reference to the height direction (e.g., +z-axis direction) of the temple 400.

In an embodiment, the heat transfer plate 450 may be positioned in the height direction (e.g., the +z-axis direction) of the temple with reference to the printed circuit board 430. A part of the heat transfer plate 450 may be in contact with the printed circuit board 430. For example, the contact area 451 of the heat transfer plate 450 may be in contact with the printed circuit board 430.

Referring to FIG. 7B, the second heat transfer member 470 may be disposed such that multiple layers constituting the second heat transfer member 470 are wound and stacked.

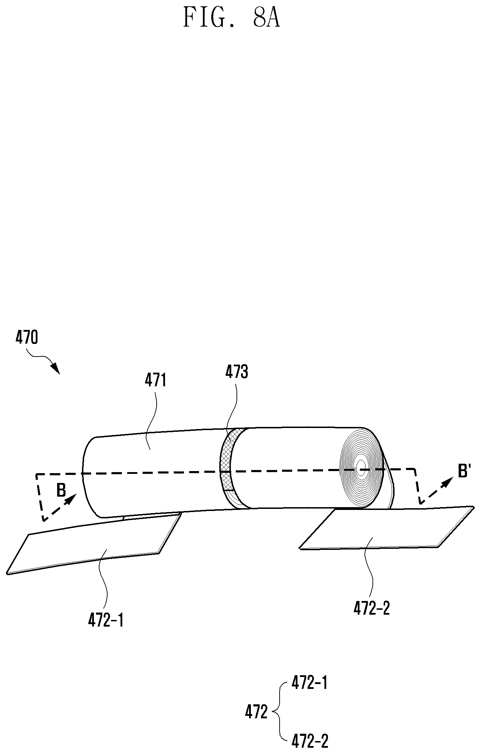

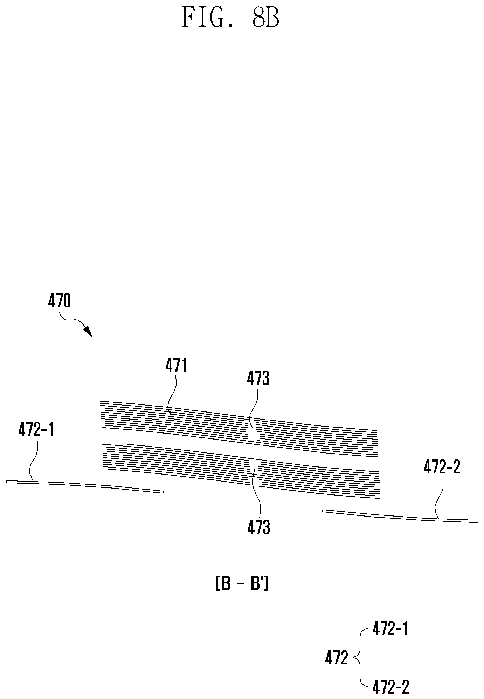

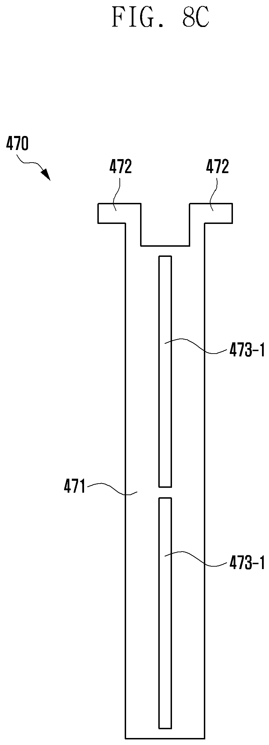

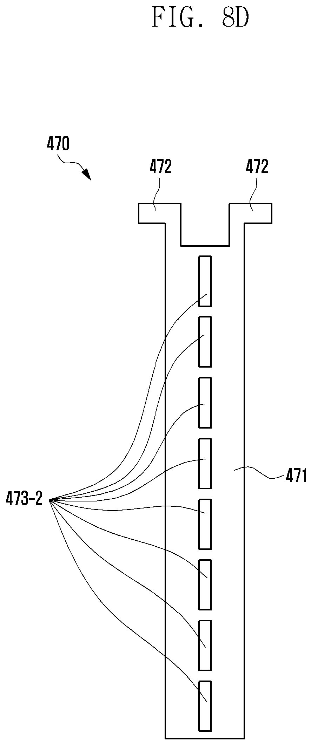

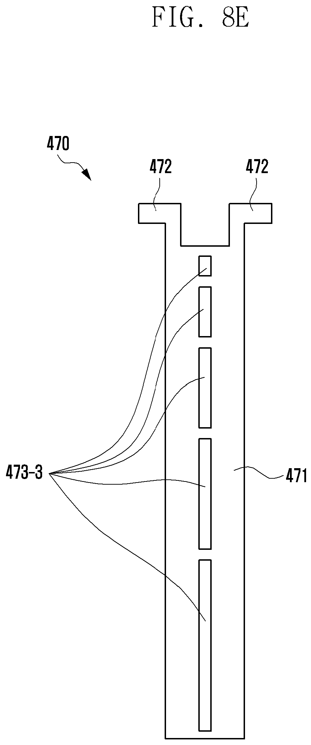

FIG. 8A, FIG. 8B, FIG. 8C, FIG. 8D, and FIG. 8E are views showing a second heat transfer member 470 according to an embodiment of the disclosure.

FIG. 8A is a perspective view of a second heat transfer member 470 according to an embodiment of the disclosure.

FIG. 8B is a cross-sectional view of a second heat transfer member 470 taken along line B-B' in FIG. 8A according to an embodiment of the disclosure.

FIG. 8C, FIG. 8D, and FIG. 8E are development views of a second heat transfer member 470 according to an embodiment of the disclosure.

In an embodiment, the second heat transfer member 470 may include a roll area 471, a plate area 472, and/or a slit 473.

Referring to FIG. 8A, the roll area 471 of the second heat transfer member 470 may mean an area in which a part of the second heat transfer member 470 is wound into a roll shape and stacked. For example, the second heat transfer member 470 may be disposed such that the surface forming the second heat transfer member 470 in the roll area 471 is wound into a roll shape and stacked.

Referring to FIG. 8A, the plate area 472 of the second heat transfer member 470 may be an area extending from the outermost portion of the roll area 471. For example, the plate area 472 may be formed to extend from the terminal end of an area positioned at the outermost of a roll area 471 having a roll shape.

In an embodiment, the plate area 472 may also be manufactured separately from the roll area 471. For example, the plate area 472 and the roll area 471 may be manufactured separately, and then the plate area 472 may be coupled to a part of the roll area 471 through an adhesive member.

In an embodiment, the plate area 472 may include a first plate area 472-1 and/or a second plate area 472-2. The first plate area 472-1 and the second plate area 472-2 may be formed symmetrically with reference to the roll area 471. For example, the first plate area 472-1 may be disposed at one side of the roll area 471, and the second plate area 472-2 may be disposed at the other side of the roll area 471.

In an embodiment, the second heat transfer member 470 may include a slit 473 formed in at least a part thereof. The slit 473 may be formed to extend along the direction in which the roll area 471 of the second heat transfer member 470 extends. The slit 473 may mean a groove or opening formed along the direction in which the roll area 471 extends.

**In** FIG. 8B, FIG. 8C, FIG. 8D, and FIG. 8E, although it is illustrated that the slit 473 extends along the center part of the roll area 471, the position of the slit 473 may be an example, and the position at which the slit 473 is formed may not be limited thereto. For example, the slit 473 may also be disposed between the center part of the roll area 471 and one side of the roll area 471, or may also be disposed between the center part of the roll area 471 and the other side of the roll area 471.

Referring to FIG. 8C, the second heat transfer member 470 may include a long slit 473-1 formed in a part of the roll area 471. For example, the second heat transfer member 470 may include a long slit 473-1 formed to extend relatively long compared to a short slit 473-2 in FIG. 8D.

In an embodiment, multiple long slits 473-1 may be formed to extend along the direction in which the roll area 471 extends. For example, multiple long slits 473-1 in the roll area 471 may be arranged to be spaced a predetermined interval apart from each other along the direction in which the roll area 471 extends.

Although FIG. 8C illustrates that the second heat transfer member 470 includes two long slits 473-1, it may be an example, and the number of long slits 473-1 included in the second heat transfer member 470 may not be limited thereto. For example, the second heat transfer member 470 may include only one long slit 473-1 or may include three or more long slits 473-1.

Referring to FIG. 8D, the second heat transfer member 470 may include a short slit 473-2 formed in a part of the roll area 471. The short slit 473-2 may be formed to extend relatively short compared to the long slit 473-1 in FIG. 8C.

Referring to FIG. 8D, multiple short slits 473-2 may be formed to extend along the direction in which the roll area 471 extends. For example, multiple short slits 473-2 in the roll area 471 may be arranged to be spaced a predetermined interval apart from each other along the direction in which the roll area 471 extends.

Although FIG. 8D illustrates that the second heat transfer member 470 includes eight short slits 473-2, it may be example, and the number of short slits 473-2 included in the second heat transfer member 470 may not be limited thereto. For example, the second heat transfer member 470 may include only 7 or less short slits 473-2, or may include 9 or more short slits 473-2.

Referring to FIG. 8E, the second heat transfer member 470 may include multiple variable length slits 473-3 formed in a part of the roll area 471. The multiple variable length slits 473-3 may be formed to have different extension lengths.

Referring to FIG. 8E, the multiple variable length slits 473-3 may be formed to extend along the direction in which the roll area 471 extends. For example, the multiple variable length slits 473-3 in the roll area 471 may be arranged to be spaced a predetermined interval apart from each other along the direction in which the roll area 471 extends.

In an embodiment, the extension lengths of the variable length slits 473-3 may be formed to be longer as the variable length slits 473-3 are positioned farther away from the plate area 472.

Although FIG. 8E illustrates that the variable length slits 473-3 positioned farther away from the plate area 472 have long extension lengths, it may be an example, and the extension lengths of the variable length slits 473-3 may not be limited thereto. For example, the variable length slits 473-3 positioned close to the plate area 472 may also be formed to have a relatively longer length.

Although FIG. 8E illustrates that the second heat transfer member 470 includes five variable length slits 473-3, it may be example, and the number of variable length slits 473-3 included in the second heat transfer member 470 may not be limited thereto.

In an embodiment, in case that the slit 473 is not formed in the second heat transfer member 470, the temple 400 (see FIG. 4) may not be easily bent in the bendable area 412 (see FIG. 5A) of the first housing 410 (see FIG. 5A) due to the resistance of the second heat transfer member 470. In case that the slit 473 is formed in the second heat transfer member 470, the resistance of the second heat transfer member 470 may be reduced so that the temple 400 (see FIG. 4) can be easily bent in the bendable area 412 (see FIG. 5A).

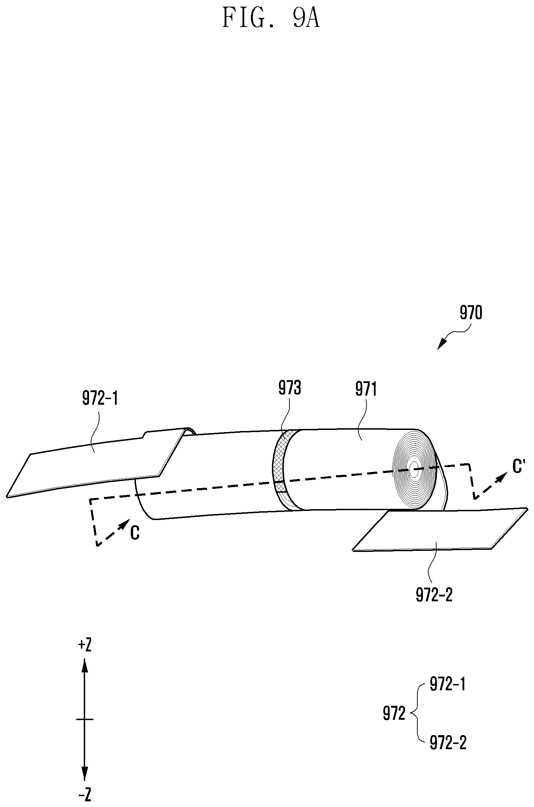

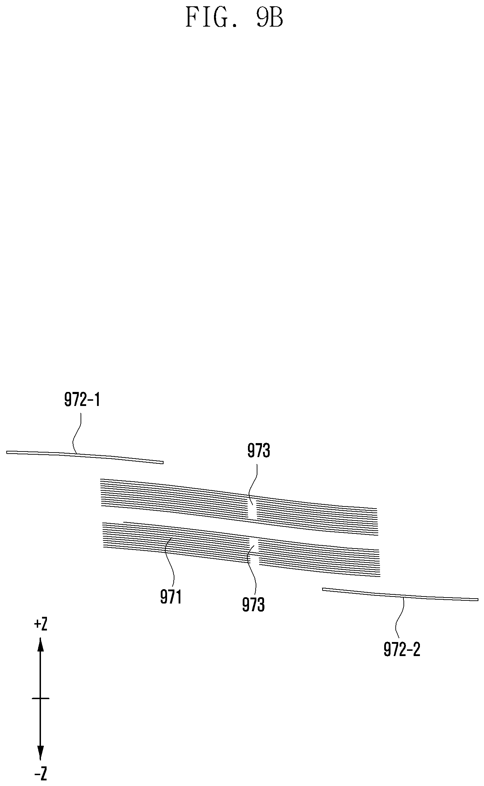

FIG. 9A and FIG. 9B are views showing a second heat transfer member 970 according to an embodiment of the disclosure.

FIG. 9A is a view showing a second heat transfer member 970 according to an embodiment of the disclosure.

FIG. 9B is a cross-sectional view of a second heat transfer member 970 taken along line C-C' in FIG. 9A.

The second heat transfer member 970 according to an embodiment of the disclosure may include a roll area 971, a plate area 972, and/or a slit 973.

The plate area 972 of the second heat transfer member 970 according to an embodiment of the disclosure may include a first plate area 972-1 and/or a second plate area 972-2.

In an embodiment, the first plate area 972-1 may be disposed at one side of the roll area 971, and the second plate area 972-2 may be disposed at the other side (e.g., the side surface opposite to one side of the roll area 971) of the roll area 971.

Referring to FIG. 9A and FIG. 9B, the first plate area 972-1 may be disposed in the direction opposite to the direction in which the second plate area 972-2 is disposed in the roll area 971. For example, the first plate area 972-1 may be disposed in the +z-axis direction with reference to the roll area 971, and the second plate area 972-2 may be disposed in the -z-axis direction with reference to the roll area 971.

In an embodiment, the first plate area 972-1 and the second plate area 972-2 may be arranged to face different areas of the temple 400 (see FIG. 4). For example, the first plate area 972-1 may be disposed to face the first housing 410 (see FIG. 4), and the second plate area 972-2 may be disposed to face the second housing 490 (see FIG. 4).

Although FIG. 9A and FIG. 9B illustrate two plate areas 972, it may be example, and the number of plate areas 972 included in the second heat transfer member 970 may not be limited thereto.

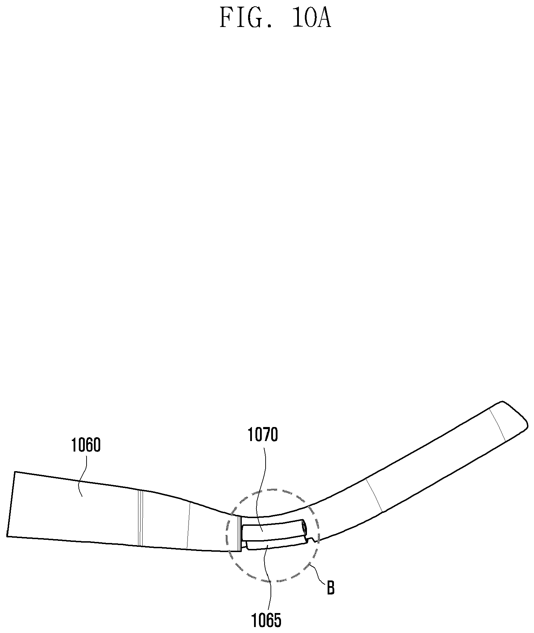

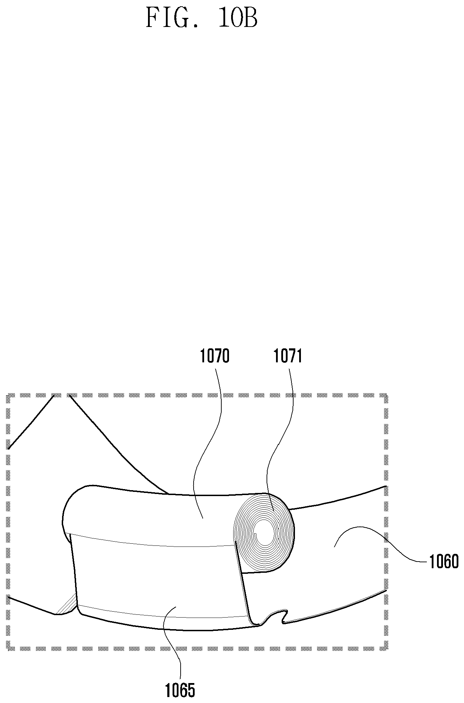

FIG. 10A and FIG. 10B are views showing a first heat transfer member 1060 and a second heat transfer member 1070 integrally formed according to an embodiment of the disclosure.

FIG. 10A is a view showing a first heat transfer member 1060 and a second heat transfer member 1070 according to an embodiment of the disclosure.

FIG. 10B is an enlarged view of area B illustrated in FIG. 10A.

In an embodiment, the first heat transfer member 1060 and the second heat transfer member 1070 may be formed integrally. For example, instead of adhering the second heat transfer member 1070 to the first heat transfer member 1060 after separately manufacturing the second heat transfer member 1070, a part of the first heat transfer member 1060 may be processed so that the second heat transfer member 1070 can be formed.

Referring to FIG. 10A and FIG. 10B, the first heat transfer member 1060 may extend to a connection area 1065 so as to be connected to the second heat transfer member 1070. For example, the connection area 1065 may be formed to extend in a direction substantially perpendicular to one surface of the first heat transfer member 1060. The connection area 1065 may have one end connected to the first heat transfer member 1060, and the other end connected to the second heat transfer member 1070.

Referring to FIG. 10A and FIG. 10B, the second heat transfer member 1070 may include a roll area 1071. The roll area 1071 may mean an area in which a part of the second heat transfer member 1070 is wound into a roll shape and stacked.

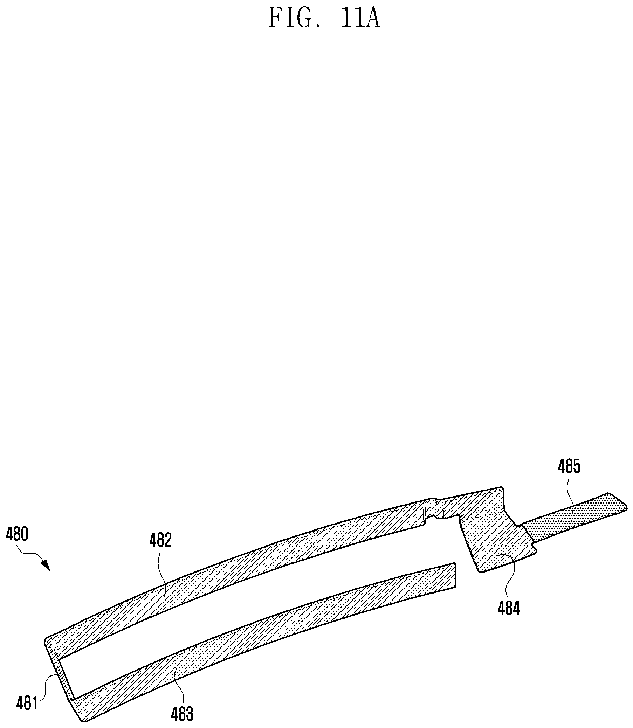

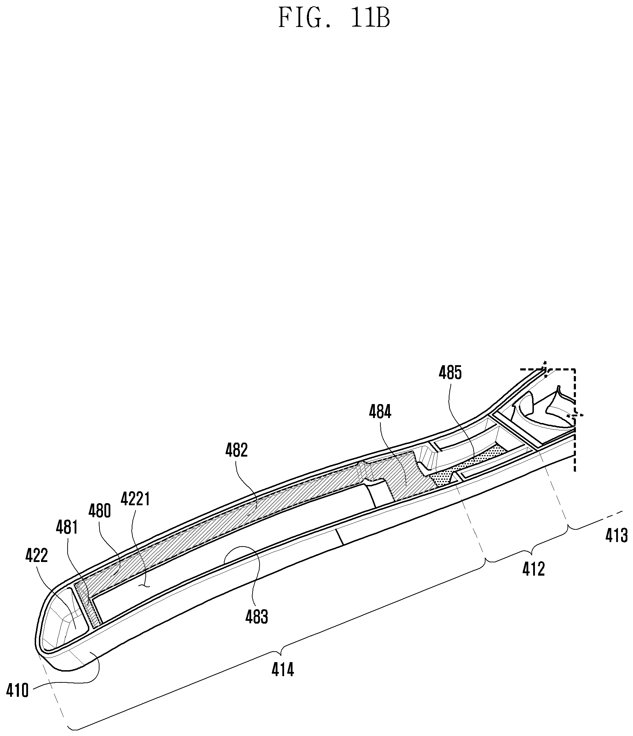

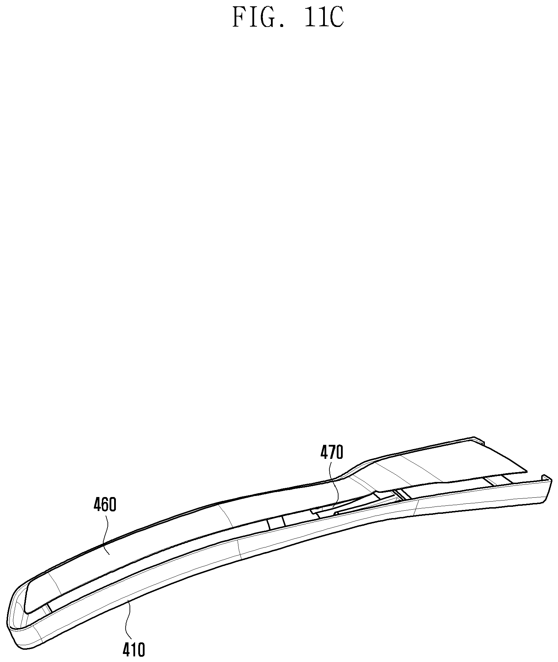

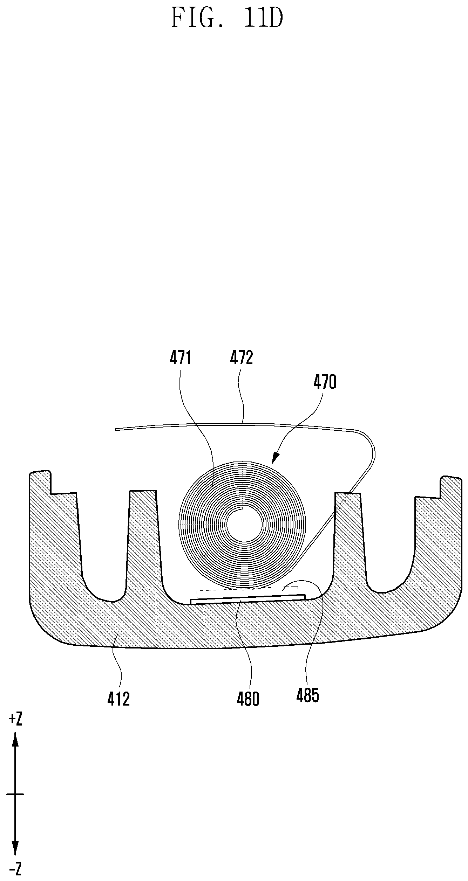

FIG. 11A, FIG. 11B, FIG. 11C, and FIG. 11D are views showing a first housing 410 and a third heat transfer member 480 according to an embodiment of the disclosure.

FIG. 11A is a view showing a third heat transfer member 480 according to an embodiment of the disclosure.

FIG. 11B is a view showing a third heat transfer member 480 disposed in a first housing 410 according to an embodiment of the disclosure.

FIG. 11C is a view showing a first housing 410, a first heat transfer member 460, and a second heat transfer member 470 according to an embodiment of the disclosure.

FIG. 11D is a view showing the arrangement between a second heat transfer member 470 and a third heat transfer member 480 according to an embodiment of the disclosure.

In an embodiment, the third heat transfer member 480 may include a first transfer surface 481, a second transfer surface 482, a third transfer surface 483, and/or a fourth transfer surface 484.

Referring to FIG. 11A, the second transfer surface 482 may be disposed to face the third transfer surface 483 while being spaced apart from the third transfer surface 483. The first transfer surface 481 may extend between the second transfer surface 482 and the third transfer surface 483, and may have one end connected to the second transfer surface 482 and the other end connected to the third transfer surface 483.

Referring to FIG. 11A, the fourth transfer surface 484 may be formed to extend from the terminal end of the second transfer surface 482 and to be substantially perpendicular to the second transfer surface 482. The first transfer surface 481 may be connected to one end of the second transfer surface 482, and a fourth transfer surface 484 may be connected to the other end of the second transfer surface 482.

In an embodiment, the third heat transfer member 480 may be disposed to surround at least a part of the battery 440 (see FIG. 4). For example, the first transfer surface 481, the second transfer surface 482, and the third transfer surface 483 of the third heat transfer member 480 may be arranged to surround the periphery of the battery 440.

In an embodiment, the heat dissipating member 485 may be disposed on one surface of the fourth transfer surface 484. For example, the fourth transfer surface 484 may have at least a part extending in a direction opposite to the first transfer surface 481, and the heat dissipating member 485 may be disposed on one surface of the fourth transfer surface 484, which extends in a direction opposite to the first transfer surface 481.

Referring to FIG. 11B, the third heat transfer member 480 may be disposed on the second bracket 422 positioned in the second area 414 of the first housing 410. For example, at least a part of the third heat transfer member 480 may be disposed in the second space 4221 formed in the second bracket 422.

In an embodiment, the third heat transfer member 480 may have at least a part in contact with the second bracket 422. For example, the first transfer surface 481, the second transfer surface 482, and the third transfer surface 483 of the third heat transfer member 480 may be arranged to be in contact with the inner surface of the second bracket 422. The third heat transfer member 480 may transfer heat to the second bracket 422 or receive heat from the second bracket 422.

Referring to FIG. 11B, the heat dissipating member 485 may have at least a part disposed in the bendable area 412 of the first housing 410. For example, the heat dissipating member 485 may be disposed in the bendable area 412 and may extend in the direction from the second area 414 toward the first area 413 of the first housing 410.

Referring to FIG. 11C, the first heat transfer member 460 may have a shape extending along the direction in which the first housing 410 extends. The second heat transfer member 470 may be disposed on one surface (e.g., the surface facing the first housing 410 from the first heat transfer member 460) of the first heat transfer member 460.

Referring to FIG. 11B, FIG. 11C, and FIG. 11D, the second heat transfer member 470 and the heat dissipating member 485 may be positioned at positions corresponding to each other. For example, each of the second heat transfer member 470 and the heat dissipating member 485 may be disposed in the bendable area 412 of the first housing 410.

Referring to FIG. 11D, the third heat transfer member 480 may be disposed on one surface of the bendable area 412 of the first housing 410. The heat dissipating member 485 may be disposed on a surface opposite to the surface on which the bendable area 412 of the first housing 410 is positioned with reference to the third heat transfer member 480.

Referring to FIG. 11D, the second heat transfer member 470 may be disposed on one surface of the heat dissipating member 485, and at least a part of the third heat transfer member 480 may be disposed on the other surface of the heat dissipating member 485. For example, the second heat transfer member 470 may be disposed on one surface of the heat dissipating member 485 to be in contact with the heat dissipating member 485, and the third heat transfer member 480 may be disposed on the other surface of the heat dissipating member 485 to be in contact with the heat dissipating member 485.

Referring to FIG. 11D, the second heat transfer member 470 may include a roll area 471 wound into a roll shape and stacked and/or a plate area 472 formed to extend from the roll area 471. The plate area 472 may be formed in a direction opposite to the direction in which the bendable area 412 of the first housing 410 and the third heat transfer member 480 are positioned with reference to the roll area 471. The second heat transfer member 470 may be in contact with the heat dissipating member 485 in the roll area 471, and may be in contact with the first heat transfer member 460 in the plate area 472.

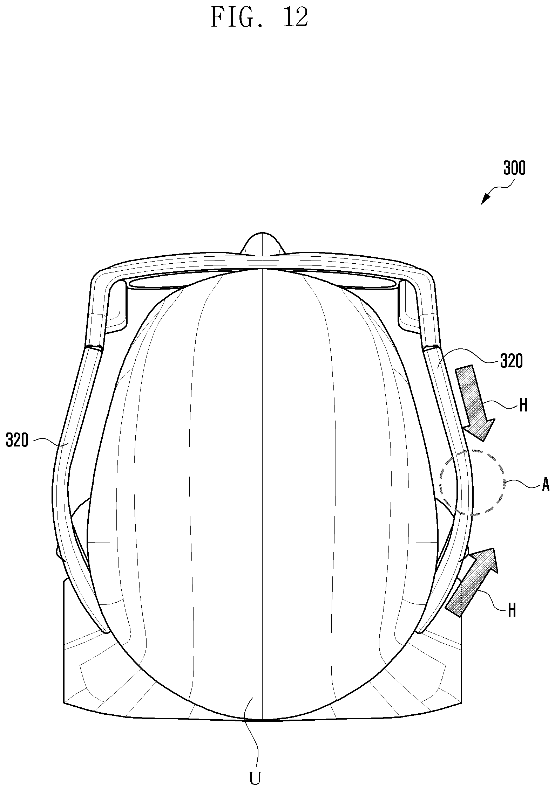

FIG. 12 is a view showing a heat flow H generated during operation of an electronic device 300 according to an embodiment of the disclosure.

FIG. 12 shows a heat flow H generated in the electronic device 300 in a state where a user U wears the electronic device 300 and uses the electronic device 300.

In an embodiment, area A illustrated in FIG. 12 may mean an area in which the bendable area 412 (see FIG. 5A) of the temple 320 is positioned.

Referring to FIG. 12, the heat flow H generated in a temple 320 of the electronic device 300 may be formed in the direction from other areas of the temple 320 toward area A. For example, the heat generated in the printed circuit board 430 (see FIG. 4) and the battery 440 (see FIG. 4) of the temple 320 may be transferred to the second heat transfer member 470 (see FIG. 4) disposed in area A through the first heat transfer member 460 (see FIG. 4) and the third heat transfer member 480 (see FIG. 4).

In an embodiment, area A may be an area of a temple 320, which is not in direct contact with the user U. Since the heat of the electronic device 300 is transferred to area A of the temple 320, which is not in direct contact with the user U, the user U can wear the electronic device 300 while being less affected by heat generated in the electronic device 300.

In an embodiment, the temple 320 including heat transfer members 460, 470, and 480 (see FIG. 4) may form a heat flow H toward area A to prevent the temperature inside the temple 320 from being formed above a predetermined temperature. In case that the temperature inside the temple 320 is formed below a predetermined temperature, malfunction of the electronic device 300 including the temple 320 can be prevented.

An electronic device 300 according to an embodiment of the disclosure may include a glass member 340, a rim 310 disposed to surround a periphery of the glass member 340, and a temple 320 connected to the rim 310, wherein the temple 320 includes housings 410 and 490 including a bendable area 412 which is elastically bendable, a printed circuit board 430 disposed inside the housings 410 and 490 to be spaced apart from one end of the bendable area 412, a battery 440 disposed inside the housings 410 and 490 to be spaced apart from the other end of the bendable area 412, a first heat transfer member 460 which is disposed inside the housings 410 and 490, extends to have a plate shape extending along the direction in which the housings 410 and 490 extend, and is in contact with the printed circuit board 430 and the battery 440, and a second heat transfer member 470 disposed in the bendable area 412 of the housings 410 and 490 and in contact with the first heat transfer member 460, wherein the bendable area 412 includes a material which allows the bendable area to be easily bent compared to other areas of the housings 410 and 490, and wherein the second heat transfer member 470 includes a slit 473 in at least a part thereof and is disposed to be wound and stacked at least once.

In an embodiment, the housing 410 and 490 may include a first housing 410 including the bendable area 412 and an accommodation space 411 in which the printed circuit board and the battery are arranged, and a second housing 490 which is disposed to cover the first housing 410 and extends to have a shape corresponding to the first housing 410.

In an embodiment, the temple may further include a heat transfer plate 450 having one surface in contact with the first heat transfer member 460 and the other surface in contact with the printed circuit board 430, and the first heat transfer member 460 may be disposed in the second housing 490.

In an embodiment, the first housing 410 may further include a first area 413 which is positioned at the one end of the bendable area 412 and in which the printed circuit board 430 is disposed, and a second area 414 which is positioned at the other end of the bendable area 412 and in which the battery is disposed, the bendable area 412 may include a urethane material, and each of the first area 413 and the second area 414 may include a plastic material in at least a part of the inside thereof.

In an embodiment, the temple 400 may further include a first bracket 421 which is disposed in the first area 413 and includes a first accommodation space 4211 in which the printed circuit board 430 is disposed, and a second bracket 422 which is disposed in the second area and includes a second accommodation space 4221 in which the battery 440 is disposed, and the first bracket 421 and the second bracket 422 may include plastic materials.

In an embodiment, the second heat transfer member 470 may include a roll area 471 which is formed in a roll shape and in which at least a part of the second heat transfer member 470 is wound and stacked.

In an embodiment, the second heat transfer member 470 may further include a plate area 472 which extends from a terminal end of the roll area 471, is formed in a plate shape, and is in contact with the first heat transfer member 460.

In an embodiment, the second heat transfer member 470 may include two plate areas 472, and each of the two plate areas 472 may have one surface adhered to the first heat transfer member 460.

In an embodiment, the second heat transfer member 970 may further include a plate area 972 which extends from a terminal end of the roll area 971, is formed in a plate shape, and is in contact with a member positioned outside the second heat transfer member, the second heat transfer member 970 may include two plate areas 972, and the two plate areas 972 may be arranged in opposite directions with reference to the roll area 971.

In an embodiment, the temple 400 may further include a third heat transfer member 480 disposed to surround at least a part of the battery 440.

In an embodiment, the temple 400 may further include a heat dissipating member 485 disposed at a terminal end of the third heat transfer member 480 and in contact with the second heat transfer member 470.

In an embodiment, the third heat transfer member 480 may include a first transfer surface 481, a second transfer surface 482, a third transfer surface 483, and a fourth transfer surface 484.

In an embodiment, the first transfer surface 481, the second transfer surface 482, and the third transfer surface 483 may be arranged to surround at least a part of a periphery of the battery 440.

In an embodiment, the first transfer surface 481 may extend between the second transfer surface 482 and the third transfer surface 483.

In an embodiment, the second transfer surface 482 and the third transfer surface 483 may be arranged to face each other while being spaced apart from each other.

In an embodiment, the fourth transfer surface 484 may be formed to extend from a terminal end of the second transfer surface 482 and to be perpendicular to the second transfer surface 482.

In an embodiment, the fourth transfer surface 484 may have one surface on which the heat dissipating member 485 is disposed.

In an embodiment, the second heat transfer member 1070 may be integrally manufactured with the first heat transfer member 1060 and be formed to extend from at least a part of the first heat transfer member 1060.

In an embodiment, the second heat transfer member 470 may include multiple slits 473, and the multiple slits 473 may be arranged to be spaced apart from each other along a direction in which the second heat transfer member 470 extends.

In an embodiment, the multiple slits 473-3 may be formed to extend while having different lengths, respectively.

A temple 400 of a wearable electronic device according to an embodiment of the disclosure may include housings 410 and 490 including a bendable area 412 which is elastically bendable, a printed circuit board 430 disposed inside the housings 410 and 490 to be spaced apart from one end of the bendable area 412, a battery 440 disposed inside the housings 410 and 490 to be spaced apart from the other end of the bendable area 412, a first heat transfer member 460 which is disposed inside the housings 410 and 490, extends to have a plate shape extending along the direction in which the housings 410 and 490 extend, and is in contact with the printed circuit board 430 and the battery 440, and a second heat transfer member 470 disposed in the bendable area 412 of the housings 410 and 490 and in contact with the first heat transfer member 460, wherein the bendable area 412 includes a material which allows the bendable area to be easily bent compared to other areas of the housings 410 and 490, and the second heat transfer member 470 includes a slit 473 in at least a part thereof and is disposed to be wound and stacked at least once.

An electronic device according to an embodiment of the disclosure may be various types of devices. For example, the electronic device may include a portable communication device (e.g., a smartphone), a computer device, a portable multimedia device, a portable medical device, a camera, a wearable device, or a home appliance device.

It should be understood that embodiments of the disclosure and the terms used herein are not intended to limit the technical features described in the disclosure to specific embodiments, but include various modifications, equivalents, or replacements for a corresponding embodiment. In connection with the description of the drawings, the similar reference numerals may be used to refer to similar or related elements. A singular form of a noun corresponding to an item may include one or more of the items, unless the context clearly indicates otherwise. Such terms as "first" and "second", or "1th" and "2th" may be used to simply distinguish corresponding elements from other elements, and do not limit the corresponding elements in another aspect (e.g., importance or order). In case that an element (e.g., a first element) is referred to as being "coupled to" or "connected to" another element (e.g., a second element) with or without the term "functionally" or "communicatively", it means that the element may be coupled to another element directly (e.g., wiredly), wirelessly, or through a third element.

The term "module" used in the embodiments of the disclosure may include a unit implemented as hardware, software, or firmware, and for example, may be used interchangeably with the term "logic", "logical block", "component", or "circuit". The module may be a minimum unit or a part of integrated components or of a component performing one or more functions. For example, according to an embodiment, the module may be implemented in the form of an application-specific integrated circuit (ASIC).

An embodiment of the disclosure may be implemented as software (e.g., the program 140) including one or more instructions stored in a storage medium (e.g., the internal memory 136 or the external storage 138) which can be read by a machine (e.g., the electronic device 101). For example, a processor (e.g., the processor 120) of a machine (e.g., the electronic device 101) can fetch at least one of the stored instructions from the storage medium and execute the fetched instruction. When at least one instruction of the fetched instructions is executed by the processor, the machine may perform a function corresponding to the fetched instruction. The one or more instructions may include a code generated by a compiler and a code executable by an interpreter. The machine-readable storage medium may be provided in the form of a non-transitory storage medium. Here, "non-transitory" merely means that the storage medium is a tangible device and does not include a signal (e.g., an electromagnetic wave), and the term does not distinguish whether data is stored semi-permanently or temporarily in the storage medium.

A method according to an embodiment of the disclosure may be provided in the manner of being included in a computer program product. A computer program product may be traded between a seller and a purchaser as a commodity. The computer program product may be distributed in the form of a machine-readable storage medium (e.g., a compact disc only-read-only memory (CD-ROM)) or in on-line (e.g., downloaded or uploaded) via an application store (e.g., playstore^{™}) or between two user devices (e.g., smartphones). In the case of on-line distribution, at least a part of the computer program product maybe temporarily stored in or temporarily produced from a storage medium such as a manufacturer's server, a server of an application store, or a memory of a relay server.

According to an embodiment, each (e.g., a module or a program) of the elements described above may include a single unit or multiple units, and some of the multiple units may also be separately arranged to another element. According to an embodiment, one or more of the elements or operations described above may be omitted, or one or more other elements or operation may be added. Alternatively or additionally, multiple elements (e.g., modules or programs) may be integrated into a single element. In this case, the integrated element may perform one or more functions which are the same as or similar to the functions performed by each of the multiple elements prior to the integration. According to an embodiment, operations performed by a module, a programming module, or other elements may be executed sequentially, in parallel, repeatedly, or in a heuristic manner. One or more operations of the operations may be executed according to another sequence or may be omitted. In addition, one or more other operations may be added.

## Claims

1. An electronic device (300) comprising:
a glass member (340);
a rim (310) disposed to surround a periphery of the glass member (340); and
a temple (320) connected to the rim (310),
wherein the temple (320) comprises:
a housing comprising a bendable area (412) which is elastically bendable;
a printed circuit board (430) disposed inside the housing to be spaced apart from one end of the bendable area (412);
a battery (440) disposed inside the housing to be spaced apart from the other end of the bendable area; (412)
a first heat transfer member (460) which is disposed inside the housing, extends to have a plate shape extending along the direction in which the housing extends, and is in contact with the printed circuit board (430) and the battery; and
a second heat transfer member (470) disposed in the bendable area (412) of the housing and in contact with the first heat transfer member, (460)
wherein the bendable area (412) comprises a material which allows the bendable area (412) to be easily bent compared to other areas of the housing, and
wherein the second heat transfer member (470) comprises a slit (473) in at least a part thereof and is disposed to be wound and stacked at least once.

2. The electronic device of claim 1, wherein the housing comprises:
a first housing comprising an accommodation space in which the printed circuit board and the battery are arranged and the bendable area; and
a second housing which is disposed to cover the first housing and extends to have a shape corresponding to the first housing.

3. The electronic device of claim 2, wherein the temple further comprises a heat transfer plate having one surface in contact with the first heat transfer member and the other surface in contact with the printed circuit board, and
wherein the first heat transfer member is disposed in the second housing.

4. The electronic device of one of claims 2 to 3, wherein the first housing further comprises:
a first area which is positioned at the one end of the bendable area and in which the printed circuit board is disposed; and
a second area which is positioned at the other end of the bendable area and in which the battery is disposed,
wherein the bendable area comprises a urethane material, and
wherein each of the first area and the second area comprises a plastic material in at least a part of the inside thereof.

5. The electronic device of claim 4, wherein the temple further comprises:
a first bracket which is disposed in the first area and comprises a first accommodation space in which the printed circuit board is disposed; and
a second bracket which is disposed in the second area and comprises a second accommodation space in which the battery is disposed, and
wherein the first bracket and the second bracket comprise plastic materials.

6. The electronic device of one of claims 1 to 5, wherein the second heat transfer member comprises a roll area which is formed in a roll shape and in which at least a part of the second heat transfer member is wound and stacked.

7. The electronic device of claim 6, wherein the second heat transfer member further comprises a plate area which extends from a terminal end of the roll area, is formed in a plate shape, and is in contact with the first heat transfer member.

8. The electronic device of claim 7, wherein the second heat transfer member comprises two plate areas, and
wherein each of the two plate areas has one surface adhered to the first heat transfer member.

9. The electronic device of claim 6, wherein the second heat transfer member further comprises a plate area which extends from a terminal end of the roll area, is formed in a plate shape, and is in contact with a member positioned outside the second heat transfer member,
wherein the second heat transfer member comprises two plate areas, and
wherein the two plate areas are arranged in directions opposite to each other with reference to the roll area.

10. The electronic device of one of claims 1 to 9, wherein the temple further comprises a third heat transfer member disposed to surround at least a part of the battery.

11. The electronic device of claim 10, wherein the temple further comprises a heat dissipating member disposed at a terminal end of the third heat transfer member and in contact with the second heat transfer member.

12. The electronic device of claim 11, wherein the third heat transfer member comprises a first transfer surface, a second transfer surface, a third transfer surface, and a fourth transfer surface,
wherein the first transfer surface, the second transfer surface, and the third transfer surface are arranged to surround at least a part of a periphery of the battery,
wherein the first transfer surface extends between the second transfer surface and the third transfer surface,
wherein the second transfer surface and the third transfer surface are arranged to face each other while being spaced apart from each other, and
wherein the fourth transfer surface is formed to extend from a terminal end of the second transfer surface and to be perpendicular to the second transfer surface and has one surface on which the heat dissipating member is disposed.

13. The electronic device of one of claims 1 to 12, wherein the second heat transfer member is integrally manufactured with the first heat transfer member and is formed to extend from at least a part of the first heat transfer member.

14. The electronic device of one of claims 1 to 13, wherein the second heat transfer member comprises multiple slits, and
wherein the multiple slits are arranged to be spaced apart from each other along a direction in which the second heat transfer member extends.

15. The electronic device of claim 14, wherein the multiple slits are formed to extend while having different lengths, respectively.

## Patentansprüche

1. Elektronische Vorrichtung (300), umfassend:
ein Glaselement (340);
einen Rand (310), der dazu vorgesehen ist, einen Umfang des Glaselements (340) zu umgeben; und
einen Bügel (320), der mit dem Rand (310) verbunden ist, wobei der Bügel (320) Folgendes umfasst:
ein Gehäuse, das einen biegbaren Bereich (412) umfasst, der elastisch biegbar ist;
eine Leiterplatte (430), die innerhalb des Gehäuses vorgesehen ist, um von einem Ende des biegbaren Bereichs (412) beabstandet zu sein;
eine Batterie (440), die innerhalb des Gehäuses vorgesehen ist, um von dem anderen Ende des biegbaren Bereichs (412) beabstandet zu sein;
ein erstes Wärmeübertragungselement (460), das innerhalb des Gehäuses vorgesehen ist, sich erstreckt, um eine Plattenform aufzuweisen, die sich entlang der Richtung erstreckt, in der sich das Gehäuse erstreckt, und in Kontakt mit der Leiterplatte (430) und der Batterie ist; und
ein zweites Wärmeübertragungselement (470), das in dem biegbaren Bereich (412) des Gehäuses vorgesehen und in Kontakt mit dem ersten Wärmeübertragungselement (460) ist,
wobei der biegbare Bereich (412) ein Material umfasst, das ermöglicht, dass der biegbare Bereich (412) verglichen mit anderen Bereichen des Gehäuses leicht gebogen wird, und
wobei das zweite Wärmeübertragungselement (470) einen Schlitz (473) in zumindest einem Teil davon umfasst und dazu vorgesehen ist, zumindest einmal gewickelt und gestapelt zu werden.

2. Elektronische Vorrichtung nach Anspruch 1, wobei das Gehäuse Folgendes umfasst:
ein erstes Gehäuse, das einen Aufnahmeraum, in dem die Leiterplatte und die Batterie angeordnet sind, und den biegbaren Bereich umfasst; und
ein zweites Gehäuse, das dazu vorgesehen ist, das erste Gehäuse abzudecken und sich so erstreckt, dass es eine Form entsprechend dem ersten Gehäuse aufweist.

3. Elektronische Vorrichtung nach Anspruch 2, wobei der Bügel ferner eine Wärmeübertragungsplatte umfasst, die eine Oberfläche in Kontakt mit dem ersten Wärmeübertragungselement und die andere Oberfläche in Kontakt mit der Leiterplatte aufweist, und
wobei das erste Wärmeübertragungselement in dem zweiten Gehäuse vorgesehen ist.

4. Elektronische Vorrichtung nach einem der Ansprüche 2 bis 3, wobei das erste Gehäuse ferner Folgendes umfasst:
einen ersten Bereich, der an dem einen Ende des biegbaren Bereichs positioniert ist und in dem die Leiterplatte vorgesehen ist; und
einen zweiten Bereich, der an dem anderen Ende des biegbaren Bereichs positioniert ist und in dem die Batterie vorgesehen ist,
wobei der biegbare Bereich ein Urethanmaterial umfasst, und
wobei jeder von dem ersten Bereich und dem zweiten Bereich ein Kunststoffmaterial in zumindest einem Teil der Innenseite davon umfasst.

5. Elektronische Vorrichtung nach Anspruch 4, wobei der Bügel ferner Folgendes umfasst:
eine erste Halterung, die in dem ersten Bereich vorgesehen ist und einen ersten Aufnahmeraum umfasst, in dem die Leiterplatte vorgesehen ist; und
eine zweite Halterung, die in dem zweiten Bereich vorgesehen ist und einen zweiten Aufnahmeraum umfasst, in dem die Batterie vorgesehen ist, und
wobei die erste Halterung und die zweite Halterung Kunststoffmaterialien umfassen.

6. Elektronische Vorrichtung nach einem der Ansprüche 1 bis 5, wobei das zweite Wärmeübertragungselement einen Rollenbereich umfasst, der in einer Rollenform gebildet ist und in dem zumindest ein Teil des zweiten Wärmeübertragungselements gewickelt und gestapelt ist.

7. Elektronische Vorrichtung nach Anspruch 6, wobei das zweite Wärmeübertragungselement ferner einen Plattenbereich umfasst, der sich von einem Anschlussende des Rollenbereichs erstreckt, in einer Plattenform gebildet ist und in Kontakt mit dem ersten Wärmeübertragungselement ist.

8. Elektronische Vorrichtung nach Anspruch 7, wobei das zweite Wärmeübertragungselement zwei Plattenbereiche umfasst, und
wobei jeder von den zwei Plattenbereichen eine Oberfläche aufweist, die an dem ersten Wärmeübertragungselement haftet.

9. Elektronische Vorrichtung nach Anspruch 6, wobei das zweite Wärmeübertragungselement ferner einen Plattenbereich umfasst, der sich von einem Anschlussende des Rollenbereichs erstreckt, in einer Plattenform gebildet ist und in Kontakt mit einem Element ist, das außerhalb des zweiten Wärmeübertragungselements positioniert ist,
wobei das zweite Wärmeübertragungselement zwei Plattenbereiche umfasst, und wobei die zwei Plattenbereiche in Richtungen entgegengesetzt zueinander in Bezug auf den Walzenbereich angeordnet sind.

10. Elektronische Vorrichtung nach einem der Ansprüche 1 bis 9, wobei der Bügel ferner ein drittes Wärmeübertragungselement umfasst, das dazu vorgesehen ist, zumindest einen Teil der Batterie zu umgeben.

11. Elektronische Vorrichtung nach Anspruch 10, wobei der Bügel ferner ein Wärmeableitungselement umfasst, das an einem Anschlussende des dritten Wärmeübertragungselements vorgesehen und in Kontakt mit dem zweiten Wärmeübertragungselement ist.

12. Elektronische Vorrichtung nach Anspruch 11, wobei das dritte Wärmeübertragungselement eine erste Übertragungsoberfläche, eine zweite Übertragungsoberfläche, eine dritte Übertragungsoberfläche und eine vierte Übertragungsoberfläche umfasst,
wobei die erste Übertragungsoberfläche, die zweite Übertragungsoberfläche und die dritte Übertragungsoberfläche dazu angeordnet sind, zumindest einen Teil eines Umfangs der Batterie zu umgeben,
wobei sich die erste Übertragungsoberfläche zwischen der zweiten Übertragungsoberfläche und der dritten Übertragungsoberfläche erstreckt,
wobei die zweite Übertragungsoberfläche und die dritte Übertragungsoberfläche dazu angeordnet sind, einander zugewandt zu sein, während sie voneinander beabstandet sind, und
wobei die vierte Übertragungsoberfläche dazu gebildet ist, sich von einem Anschlussende der zweiten Übertragungsoberfläche zu erstrecken und senkrecht zu der zweiten Übertragungsoberfläche zu sein und eine Oberfläche aufweist, auf der das Wärmeableitungselement vorgesehen ist.

13. Elektronische Vorrichtung nach einem der Ansprüche 1 bis 12, wobei das zweite Wärmeübertragungselement einstückig mit dem ersten Wärmeübertragungselement hergestellt ist und dazu gebildet ist, sich von zumindest einem Teil des ersten Wärmeübertragungselements zu erstrecken.

14. Elektronische Vorrichtung nach einem der Ansprüche 1 bis 13, wobei das zweite Wärmeübertragungselement mehrere Schlitze umfasst, und
wobei die mehreren Schlitze dazu angeordnet sind, entlang einer Richtung, in der sich das zweite Wärmeübertragungselement erstreckt, voneinander beabstandet zu sein.

15. Elektronische Vorrichtung nach Anspruch 14, wobei die mehreren Schlitze dazu gebildet sind, sich zu erstrecken, während sie jeweils unterschiedliche Längen aufweisen.

## Revendications

1. Dispositif électronique (300) comprenant :
un élément en verre (340) ;
un rebord (310) disposé pour entourer une périphérie de l'élément en verre (340) ; et
une branche (320) reliée au rebord (310), ladite branche (320) comprenant :
un boîtier comprenant une zone pliable (412) qui est pliable élastiquement ;
une carte de circuit imprimé (430) disposée à l'intérieur du boîtier pour être espacée d'une extrémité de la zone pliable (412) ;
une batterie (440) disposée à l'intérieur du boîtier pour être espacée de l'autre extrémité de la zone pliable (412) ;
un premier élément de transfert de chaleur (460) qui est disposé à l'intérieur du boîtier, s'étend pour posséder une forme de plaque s'étendant le long de la direction dans laquelle le boîtier s'étend, et est en contact avec la carte de circuit imprimé (430) et la batterie ; et
un deuxième élément de transfert de chaleur (470) disposé dans la zone pliable (412) du boîtier et en contact avec le premier élément de transfert de chaleur (460),
ladite zone pliable (412) comprenant un matériau qui permet à la zone pliable (412) d'être facilement pliée par rapport à d'autres zones du boîtier, et
ledit deuxième élément de transfert de chaleur (470) comprenant une fente (473) dans au moins une partie de celui-ci et étant disposé pour être enroulé et empilé au moins une fois.

2. Dispositif électronique de la revendication 1, ledit boîtier comprenant :
un premier boîtier comprenant un espace de logement dans lequel la carte de circuit imprimé et la batterie sont agencées et la zone pliable ; et
un second boîtier qui est disposé pour couvrir le premier boîtier et s'étend pour posséder une forme correspondant au premier boîtier.

3. Dispositif électronique de la revendication 2, ladite branche comprenant en outre une plaque de transfert de chaleur possédant une surface en contact avec le premier élément de transfert de chaleur et l'autre surface en contact avec la carte de circuit imprimé, et
ledit premier élément de transfert de chaleur étant disposé dans le second boîtier.

4. Dispositif électronique de l'une des revendications 2 à 3, ledit premier boîtier comprenant en outre :
une première zone qui est positionnée au niveau de l'extrémité de la zone pliable et dans laquelle la carte de circuit imprimé est disposée ; et
une seconde zone qui est positionnée au niveau de l'autre extrémité de la zone pliable et dans laquelle la batterie est disposée,
ladite zone pliable comprenant un matériau d'uréthane, et
chacune de la première zone et de la seconde zone comprenant une matière plastique dans au moins une partie de son intérieur.

5. Dispositif électronique de la revendication 4, ladite branche comprenant en outre :
un premier support qui est disposé dans la première zone et comprend un premier espace de logement dans lequel la carte de circuit imprimé est disposée ; et
un second support qui est disposé dans la seconde zone et comprend un second espace de logement dans lequel la batterie est disposée, et
ladite première branche et ladite seconde branche comprenant des matériaux plastiques.

6. Dispositif électronique de l'une des revendications 1 à 5, ledit deuxième élément de transfert de chaleur comprenant une zone de rouleau qui est formée en forme de rouleau et dans laquelle au moins une partie du deuxième élément de transfert de chaleur est enroulée et empilée.

7. Dispositif électronique de la revendication 6, ledit deuxième élément de transfert de chaleur comprenant en outre une zone de plaque qui s'étend à partir d'une extrémité terminale de la zone de rouleau, est formée en une forme de plaque et est en contact avec le premier élément de transfert de chaleur.

8. Dispositif électronique de la revendication 7, ledit deuxième élément de transfert de chaleur comprenant deux zones de plaque, et
chacune des deux zones de plaque possédant une surface adhérant au premier élément de transfert de chaleur.

9. Dispositif électronique de la revendication 6, ledit deuxième élément de transfert de chaleur comprenant en outre une zone de plaque qui s'étend à partir d'une extrémité terminale de la zone de rouleau, est formée en une forme de plaque et est en contact avec un élément positionné à l'extérieur du deuxième élément de transfert de chaleur,
ledit deuxième élément de transfert de chaleur comprenant deux zones de plaque, et lesdites deux zones de plaque étant agencées dans des directions opposées l'une à l'autre par rapport à la zone de rouleau.

10. Dispositif électronique de l'une des revendications 1 à 9, ladite branche comprenant en outre un troisième élément de transfert de chaleur disposé pour entourer au moins une partie de la batterie.

11. Dispositif électronique de la revendication 10, ladite branche comprenant en outre un élément de dissipation de chaleur disposé au niveau d'une extrémité terminale du troisième élément de transfert de chaleur et en contact avec le deuxième élément de transfert de chaleur.

12. Dispositif électronique de la revendication 11, ledit troisième élément de transfert de chaleur comprenant une première surface de transfert, une deuxième surface de transfert, une troisième surface de transfert et une quatrième surface de transfert,
ladite première surface de transfert, ladite deuxième surface de transfert et ladite troisième surface de transfert étant agencées pour entourer au moins une partie d'une périphérie de la batterie,
ladite première surface de transfert s'étendant entre la deuxième surface de transfert et la troisième surface de transfert,
ladite deuxième surface de transfert et ladite troisième surface de transfert étant agencées pour se faire face tout en étant espacées l'une de l'autre, et
ladite quatrième surface de transfert étant formée pour s'étendre à partir d'une extrémité terminale de la deuxième surface de transfert et pour être perpendiculaire à la deuxième surface de transfert et possédant une surface sur laquelle l'élément de dissipation de chaleur est disposé.

13. Dispositif électronique de l'une des revendications 1 à 12, ledit deuxième élément de transfert de chaleur étant fabriqué d'un seul tenant avec le premier élément de transfert de chaleur et étant formé pour s'étendre à partir d'au moins une partie du premier élément de transfert de chaleur.

14. Dispositif électronique de l'une des revendications 1 à 13, ledit deuxième élément de transfert de chaleur comprenant de multiples fentes, et
lesdites multiples fentes étant agencées pour être espacées les unes des autres le long d'une direction dans laquelle le deuxième élément de transfert de chaleur s'étend.

15. Dispositif électronique de la revendication 14, lesdites multiples fentes étant formées pour s'étendre tout en possédant respectivement des longueurs différentes.
